(19) Europäisches Patentamt / European Patent Office / Office européen des brevets

(11) **EP 4 343 392 A1**

(12) **EUROPEAN PATENT APPLICATION**
published in accordance with Art. 153(4) EPC

(43) Date of publication:
**27.03.2024  Bulletin 2024/13**

(21) Application number: **22804599.3**

(22) Date of filing: **13.05.2022**

(51) International Patent Classification (IPC):
*G02B 5/22* (2006.01)   *B60J 1/00* (2006.01)
*C01G 53/04* (2006.01)   *C03C 17/245* (2006.01)
*C23C 14/08* (2006.01)   *C23C 14/34* (2006.01)

(52) Cooperative Patent Classification (CPC):
**B60J 1/00; C01G 53/04; C03C 17/245;**
**C23C 14/08; C23C 14/34; G02B 5/22**

(86) International application number:
**PCT/JP2022/020170**

(87) International publication number:
**WO 2022/244686 (24.11.2022 Gazette 2022/47)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **20.05.2021  JP 2021085528**

(71) Applicant: **AGC INC.**
**Chiyoda-ku,**
**Tokyo 1008405 (JP)**

(72) Inventors:
• **YASUI, Yoji**
  **Tokyo 100-8405 (JP)**
• **TAKIMOTO, Yasuyuki**
  **Tokyo 100-8405 (JP)**

(74) Representative: **Müller-Boré & Partner**
**Patentanwälte PartG mbB**
**Friedenheimer Brücke 21**
**80639 München (DE)**

(54) **METHOD FOR PRODUCING FAR-INFRARED TRANSMISSION MEMBER, AND FAR-INFRARED TRANSMISSION MEMBER**

(57)  A manufacturing method for a far-infrared ray transmission member having a high far-infrared ray transmittance. A manufacturing method for a far-infrared ray transmission member includes forming a far-infrared ray transmission film including one or more nickel oxide layers on a base material that transmits far-infrared rays by performing sputtering in a mixed atmosphere of an Ar gas and an oxygen gas using a mixed target of NiO and Ni, wherein a content rate of NiO in the mixed target is equal to or higher than 30 mass% and lower than 100 mass% with respect to the entire mixed target, and a volume flow rate ratio of the oxygen gas in the mixed atmosphere is equal to or higher than 1% and lower than 50% with respect to a total volume flow rate of the Ar gas and the oxygen gas.

FIG.5

**Description**

Field

The present invention relates to a manufacturing method for a far-infrared ray transmission member and the far-infrared ray transmission member.

Background

For example, at the time of attaching a far-infrared sensor to a vehicle and the like, a far-infrared ray transmission film may be disposed to suppress reflection of far-infrared rays and increase an amount of transmitted light so that far-infrared rays are appropriately incident on the far-infrared sensor. For example, Non Patent Literatures 1 and 2 describe a case of forming a nickel oxide film as the far-infrared ray transmission film on an Si substrate.

It is important for the far-infrared ray transmission film for increasing an amount of transmitted light of far-infrared rays to increase a far-infrared ray transmittance by reducing an absorption loss of far-infrared rays. For example, according to Non Patent Literatures 1 and 2, a nickel oxide film having a high far-infrared ray transmittance can be obtained by performing annealing processing on a nickel oxide film formed on the Si substrate by an RF magnetron sputtering method at a temperature equal to or higher than 300°C.

Patent Literature

Non Patent Literature

Non Patent Literature 1: Hyun Bin Shim et al., Controlling the infrared optical properties of rf-sputtered NiO films for application of infrared window, Infrared Physics and Technology 72 (2015), 135-139
Non Patent Literature 2: Hyun Bin Shim et al., Nickel oxide film as an AR coating of Si window for IRsensor packaging, Infrared Technology and Applications XXXIX, Proc. of SPIE Vol, 8704 870420-1

Summary

Technical Problem

However, in a case of performing high-temperature annealing processing at 300°C or more as disclosed in Non Patent Literatures 1 and 2, there is the problem that available infrared-ray transmissive base materials are limited, a film is peeled off due to a difference in a thermal expansion coefficient between the infrared-ray transmissive base material and the far-infrared ray transmission film, and furthermore, process cost is increased. Thus, there is a demand for manufacturing a far-infrared ray transmission member having a high far-infrared ray transmittance using a method that does not require high-temperature annealing processing.

The present invention aims at providing a method for manufacturing a far-infrared ray transmission member having a high far-infrared ray transmittance without performing high-temperature annealing processing, and the far-infrared ray transmission member.

Solution to Problem

To solve the problem above, the manufacturing method for a far-infrared ray transmission member of the present disclosure includes, forming a far-infrared ray transmission film including one or more nickel oxide layers on a base material that transmits far-infrared rays by performing sputtering in a mixed atmosphere of an Ar gas and an oxygen gas using a mixed target of NiO and Ni, wherein a content rate of NiO in the mixed target is equal to or higher than 30 mass% and lower than 100 mass% with respect to the entire mixed target, and a volume flow rate ratio of the oxygen gas in the mixed atmosphere is equal to or higher than 1% and lower than 50% with respect to a total volume flow rate of the Ar gas and the oxygen gas.

The far-infrared ray transmission member of the presen disclosure comprises a base material that transmits far-infrared rays and a functional film formed on the base material, wherein the functional film includes one or more nickel oxide layers in which peak top energy of an X-ray Absorption Fine Structure (XANES) spectrum of a K-absorption edge of nickel is equal to or smaller than 8347.1 eV.

The far-infrared ray transmission member of the presen disclosure comprises a base material that transmits far-infrared rays and a functional film formed on the base material, wherein the functional film includes one or more nickel oxide layers having an extinction coefficient with respect to light having a wavelength of 10 um equal to or smaller than 0.025.

Advantageous Effects of Invention

According to the present invention, a far-infrared ray transmission member having a high far-infrared ray transmittance can be obtained without performing high-temperature annealing processing.

Brief Description of Drawings

FIG. 1 is a schematic diagram illustrating a state in which glass for vehicles according to a present embodiment is mounted on a vehicle.
FIG. 2 is a schematic plan view of the glass 1 for vehicles according to a first embodiment.
FIG. 3 is a cross-sectional view along the line A-A in FIG. 2.
FIG. 4 is a cross-sectional view along the B-B cross section in FIG. 2.
FIG. 5 is a schematic cross-sectional view of a far-infrared ray transmission member according to the present embodiment.
FIG. 6 is a schematic cross-sectional view of the far-infrared ray transmission member according to another example of the present embodiment.
FIG. 7 is a schematic cross-sectional view of the far-infrared ray transmission member according to another example of the present embodiment.
FIG. 8 is a diagram illustrating far-infrared ray transmission performance of samples of examples.
FIG. 9 is a diagram illustrating a relation between an average transmittance of samples of examples with respect to light having a wavelength from 8 um to 12 um and an extinction coefficient of a nickel oxide layer with respect to light having a wavelength of 10 um.
FIG. 10 is a diagram illustrating a relation between E(S) and an average transmittance of samples of examples with respect to light having a wavelength from 8 um to 12 um.

Description of Embodiments

The following describes a preferred embodiment of the present invention in detail with reference to the attached drawings. The present invention is not limited to the embodiment, and in a case in which there are a plurality of embodiments, the embodiments may be combined with each other. Numerical values encompass rounded numerical values.

(Vehicle)

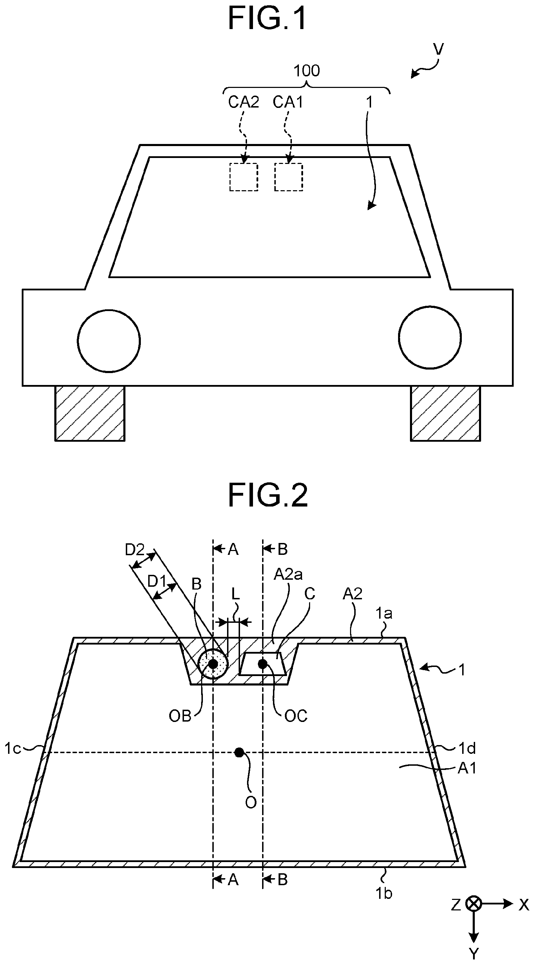

FIG. 1 is a schematic diagram illustrating a state in which glass for vehicles according to the present embodiment is mounted on a vehicle. As illustrated in FIG. 1, glass 1 for vehicles according to the present embodiment is mounted on a vehicle V. The glass 1 for vehicles is a window film applied to a windshield of the vehicle V. That is, the glass 1 for vehicles is used as a front window of the vehicle V, in other words, wind shield glass. A far-infrared camera CA1 and a visible light camera CA2 are mounted inside the vehicle V (within the vehicle). The inside of the vehicle V (within the vehicle) indicates the inside of a compartment in which a driver's seat of a driver is disposed, for example.
The glass 1 for vehicles, the far-infrared camera CA1, and the visible light camera CA2 constitute a camera unit 100 according to the present embodiment. The far-infrared camera CA1 is a camera that detects far-infrared rays, and takes a thermal image of the outside of the vehicle V by detecting far-infrared rays from the outside of the vehicle V. The visible light camera CA2 is a camera that detects visible light, and takes an image of the outside of the vehicle V by detecting visible light from the outside of the vehicle V. The camera unit 100 may further include a LiDAR or a millimetric wave radar, for example, in addition to the far-infrared camera CA1 and the visible light camera CA2. Herein, the far-infrared ray is an electromagnetic wave in a wavelength band having a wavelength from 8 um to 13 um, for example, and the visible light is an electromagnetic wave in a wavelength band having a wavelength from 360 nm to 830 nm, for example. Herein, "8 um to 13 $\mu$m" and "360 nm to 830 nm" respectively indicates "equal to or larger than 8 um and equal to or smaller than 13 um" and "equal to or larger than 360 nm and equal to or smaller than 830 nm", and the same applies to the following. The far-infrared ray may be an electromagnetic wave in a wavelength band having a wavelength from 8 um to 12 um.

(Glass for vehicles)

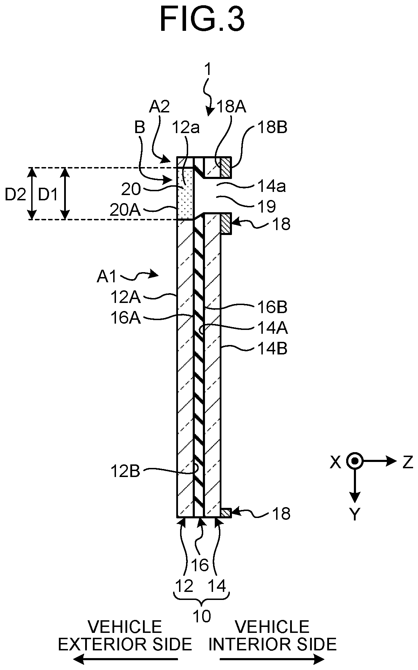

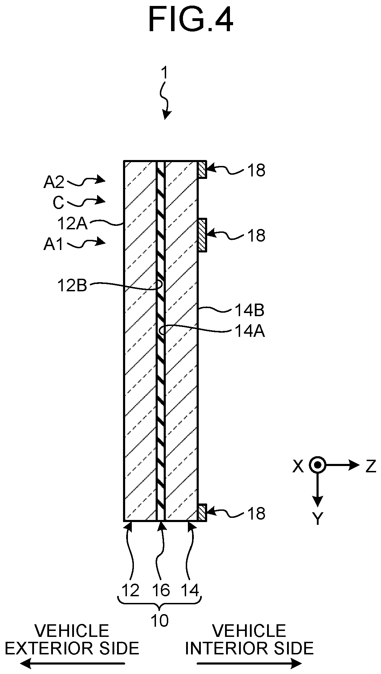

FIG. 2 is a schematic plan view of the glass 1 for vehicles according to the first embodiment. FIG. 3 is a cross-sectional view along the line A-A in FIG. 2. FIG. 4 is a cross-sectional view along the B-B cross section in FIG. 2. As illustrated in FIG. 2, an upper edge of the glass 1 for vehicles is assumed to be an upper edge part 1a, a lower edge thereof is assumed to be a lower edge part 1b, one side edge is assumed to be a side edge part 1c, and the other side edge is assumed to be a side edge part 1d hereinafter. The upper edge part 1a is an edge portion that is positioned on an upper side in a vertical direction when the glass 1 for vehicles is mounted on the vehicle V. The lower edge part 1b is an edge portion that is positioned on a lower side in the vertical direction when the glass 1 for vehicles is mounted on the vehicle V. The side edge part 1c is an edge portion that is positioned on one lateral side when the glass 1 for vehicles is mounted on the vehicle V. The side edge part 1d is an edge portion that is positioned on the other lateral side when the glass 1 for vehicles is mounted on the vehicle V.

Hereinafter, among directions parallel to a surface of the glass 1 for vehicles, a direction from the upper edge part 1a toward the lower edge part 1b is assumed to be a Y-direction, and a direction from the side edge part 1c toward the side edge part 1d is assumed to be an X-direction. The X-direction is orthogonal to the Y-direction in the present embodiment. A direction orthogonal to the surface of the glass 1 for vehicles, that is, a thickness direction of the glass 1 for vehicles is assumed to be a Z-direction. The Z-direction is, for example, a direction from a vehicle exterior side toward a vehicle interior side of the vehicle V when the glass 1 for vehicles is mounted on the vehicle V. The X-direction and the Y-direction run along the surface of the glass 1 for vehicles. However, in a case in which the surface of the glass 1 for vehicles is a curved surface, for example, the X-direction and the Y-direction may be directions being in contact with the surface of the glass 1 for vehicles at a center point 0 of the glass 1 for vehicles. The center point 0 is a center position of the glass 1 for vehicles in a case of viewing the glass 1 for vehicles from the Z-direction.

A translucent region A1 and a light blocking region A2 are formed on the glass 1 for vehicles. The translucent region A1 is a region occupying a center portion of the glass 1 for vehicles when viewed from the Z-direction. The translucent region A1 is a region for securing a visual field of the driver. The translucent region A1 is a region that transmits visible light. The light blocking region A2 is a region formed in the periphery of the translucent region A1 when viewed from the Z-direction. The light blocking region A2 is a region that blocks visible light. In the light blocking region A2, a far-infrared ray transmission region B and a visible light transmission region C are formed within a light blocking region A2a as a portion on the upper edge part 1a side.

The far-infrared ray transmission region B is a region that transmits far-infrared rays, and is a region in which the far-infrared camera CA1 is disposed. That is, the far-infrared camera CA1 is disposed at a position overlapping the far-infrared ray transmission region B when viewed from an optical axis direction of the far-infrared camera CA1. The visible light transmission region C is a region that transmits visible light, and is a region in which the visible light camera CA2 is disposed. That is, the visible light camera CA2 is disposed at a position overlapping the visible light transmission region C when viewed from an optical axis direction of the visible light camera CA2.

In this way, the far-infrared ray transmission region B and the visible light transmission region C are formed in the light blocking region A2, so that the light blocking region A2 blocks far-infrared rays in a region other than a region in which the far-infrared ray transmission region B is formed, and blocks visible light in a region other than a region in which the visible light transmission region C is formed. The light blocking region A2a is formed in the periphery of the far-infrared ray transmission region B and the visible light transmission region C. When the light blocking region A2a is disposed in the periphery, various sensors are preferably protected from sunlight. This configuration prevents wiring of various sensors from being viewed from the outside of the vehicle, so that the configuration is preferable also in view of design.

As illustrated in FIG. 3, the glass 1 for vehicles includes a glass base body 12 (first glass base body), a glass base body 14 (second glass base body), an intermediate layer 16, and a light blocking layer 18. In the glass 1 for vehicles, the glass base body 12, the intermediate layer 16, the glass base body 14, and the light blocking layer 18 are laminated in this order in the Z-direction. The glass base body 12 and the glass base body 14 are fixed (bonded) to each other via the intermediate layer 16.

As the glass base bodies 12 and 14, for example, soda-lime glass, borosilicate glass, aluminosilicate glass, or the like may be used. The intermediate layer 16 is a bonding layer that bonds the glass base body 12 to the glass base body 14. As the intermediate layer 16, for example, a polyvinyl butyral (hereinafter, also referred to as PVB) modified material, an ethylene-vinyl acetate copolymer (EVA) based material, a urethane resin material, a vinyl chloride resin material, or the like can be used. More specifically, the glass base body 12 includes one surface 12A and another surface 12B, and the other surface 12B is in contact with one surface 16A of the intermediate layer 16 to be fixed (bonded) to the intermediate layer 16. The glass base body 14 includes one surface 14A and another surface 14B, and the one surface 14A is in contact with another surface 16B of the intermediate layer 16 to be fixed (bonded) to the intermediate layer 16. As described above, the glass 1 for vehicles is laminated glass in which the glass base body 12 and the glass base body 14 are laminated. However, the glass 1 for vehicles is not limited to the laminated glass, and may include

EP 4 343 392 A1

only one of the glass base body 12 and the glass base body 14, for example. In this case, the intermediate layer 16 is not required to be disposed. Hereinafter, in a case of not distinguishing between the glass base bodies 12 and 14, they are referred to as a glass base body 10.

The light blocking layer 18 includes one surface 18A and another surface 18B, and the one surface 18A is in contact with the other surface 14B of the glass base body 14 to be fixed. The light blocking layer 18 is a layer that blocks visible light. As the light blocking layer 18, for example, a ceramics light blocking layer or a light blocking film can be used. As the ceramics light blocking layer, for example, a ceramics layer made of a conventionally known material such as a black ceramics layer can be used. As the light blocking film, for example, a light blocking polyethylene terephthalate (PET) film, a light blocking polyethylene naphthalate (PEN) film, a light blocking polymethyl methacrylate (PMMA) film, or the like can be used.

In the present embodiment, in the glass 1 for vehicles, a side on which the light blocking layer 18 is disposed is an inner side of the vehicle V (vehicle interior side), and a side on which the glass base body 12 is disposed is an outer side of the vehicle V (vehicle exterior side). However, the embodiment is not limited thereto, and the light blocking layer 18 may be disposed on the outer side of the vehicle V. In a case in which the glass 1 for vehicles is configured by the laminated glass of the glass base bodies 12 and 14, the light blocking layer 18 may be formed between the glass base body 12 and the glass base body 14.

(LIGHT BLOCKING REGION)

The light blocking region A2 is formed by disposing the light blocking layer 18 on the glass base body 10. That is, the light blocking region A2 is a region in which the glass base body 10 includes the light blocking layer 18. That is, the light blocking region A2 is a region in which the glass base body 12, the intermediate layer 16, the glass base body 14, and the light blocking layer 18 are laminated. On the other hand, the translucent region A1 is a region in which the glass base body 10 does not include the light blocking layer 18. That is, the translucent region A1 is a region in which the glass base body 12, the intermediate layer 16, and the glass base body 14 are laminated, but the light blocking layer 18 is not laminated.

(Far-infrared ray transmission region)

As illustrated in FIG. 3, an opening 19 is formed on the glass 1 for vehicles, the opening 19 passing through one surface (the surface 12A herein) and the other surface (the surface 14B herein) in the Z-direction. In the opening 19, a far-infrared ray transmission member 20 is disposed. A region in which the opening 19 is formed and the far-infrared ray transmission member 20 is disposed is the far-infrared ray transmission region B. That is, the far-infrared ray transmission region B is the region in which the opening 19 and the far-infrared ray transmission member 20 arranged in the opening 19 are disposed. The light blocking layer 18 does not transmit far-infrared rays, so that the light blocking layer 18 is not disposed in the far-infrared ray transmission region B. That is, in the far-infrared ray transmission region B, the glass base body 12, the intermediate layer 16, the glass base body 14, and the light blocking layer 18 are not disposed, and the far-infrared ray transmission member 20 is disposed in the opening 19 formed therein. The far-infrared ray transmission member 20 will be described later.

(Visible light region)

As illustrated in FIG. 4, the visible light transmission region C is a region in which the glass base body 10 does not include the light blocking layer 18 in the Z-direction similarly to the translucent region A1. That is, the visible light transmission region C is a region in which the glass base body 12, the intermediate layer 16, and the glass base body 14 are laminated, but the light blocking layer 18 is not laminated.

As illustrated in FIG. 2, the visible light transmission region C is preferably disposed in the vicinity of the far-infrared ray transmission region B. Specifically, the center of the far-infrared ray transmission region B viewed from the Z-direction is assumed to be a center point OB, and the center of the visible light transmission region C viewed from the Z-direction is assumed to be a center point OC. Where the shortest distance between the far-infrared ray transmission region B (opening 19) and the visible light transmission region C when viewed from the Z-direction is a distance L, the distance L is preferably larger than 0 mm and equal to or smaller than 100 mm, and is more preferably equal to or larger than 10 mm and equal to or smaller than 80 mm. By positioning the visible light transmission region C in the range described above with respect to the far-infrared ray transmission region B, the perspective distortion amount in the visible light transmission region C can be suppressed and an image can be appropriately taken by the visible light camera CA2 while enabling the far-infrared camera CA1 and the visible light camera CA2 to take images at close positions. By taking images at close positions by the far-infrared camera CA1 and the visible light camera CA2, a load for performing arithmetic processing on data obtained from each of the cameras is reduced, and a power supply and a signal cable can be

5

preferably handled.

As illustrated in FIG. 2, the visible light transmission region C and the far-infrared ray transmission region B are preferably positioned side by side in the X-direction. That is, it is preferable that the visible light transmission region C is not positioned on the Y-direction side with respect to the far-infrared ray transmission region B, but is positioned side by side with the far-infrared ray transmission region B in the X-direction. By arranging the visible light transmission region C side by side with the far-infrared ray transmission region B in the X-direction, the visible light transmission region C can be arranged in the vicinity of the upper edge part 1a. Accordingly, the visual field of the driver in the translucent region A1 can be appropriately secured.

(Far-infrared ray transmission member)

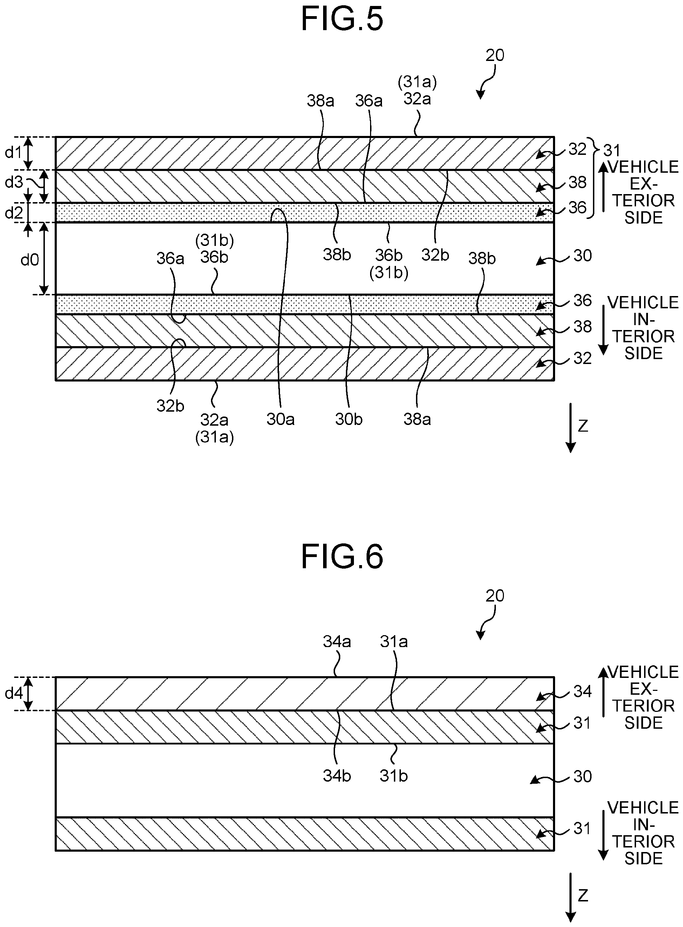

The following specifically describes the far-infrared ray transmission member 20 disposed in the far-infrared ray transmission region B. FIG. 5 is a schematic cross-sectional view of the far-infrared ray transmission member according to the present embodiment. As illustrated in FIG. 5, the far-infrared ray transmission member 20 includes a base material 30, and a far-infrared ray transmission film 31 formed on the base material 30. In the far-infrared ray transmission member 20 according to the present embodiment, far-infrared ray transmission films 31 are formed on both of one surface 30a and another surface 30b of the base material 30. The surface 30a is a surface on the vehicle interior side in a case of being mounted on the glass 1 for vehicles, and the surface 30b is a surface on the vehicle exterior side in a case of being mounted on the glass 1 for vehicles. However, in the far-infrared ray transmission member 20, the far-infrared ray transmission films 31 are not necessarily formed on both of the surfaces 30a and 30b of the base material 30. The far-infrared ray transmission film 31 may be formed on at least one of the surfaces 30a and 30b.

In this way, in the present embodiment, the far-infrared ray transmission member 20 is disposed in the light blocking region A2 of the glass 1 for vehicles as the window film of the vehicle V, but the embodiment is not limited thereto. The far-infrared ray transmission member 20 may be disposed on an optional exterior film of the vehicle V such as an exterior film for a pillar of the vehicle V. The far-infrared ray transmission member 20 is not only disposed on the vehicle V but also may be used for optional use.

(Base material)

The base material 30 is a member that can transmit far-infrared rays. An internal transmittance of the base material 30 with respect to light having a wavelength of 10 um (far-infrared rays) is preferably equal to or larger than 50%, more preferably equal to or larger than 60%, and even more preferably equal to or larger than 70%. An average internal transmittance of the base material 30 with respect to light having a wavelength from 8 um to 12 um (far-infrared rays) is preferably equal to or larger than 50%, more preferably equal to or larger than 60%, and even more preferably equal to or larger than 70%. When the internal transmittance of the base material 30 with respect to 10 um and the average internal transmittance thereof with respect to 8 um to 12 um fall within this numerical range, far-infrared rays can be appropriately transmitted, and performance of the far-infrared camera CA1 can be sufficiently exhibited, for example. The average internal transmittance herein means an average value of internal transmittances with respect to pieces of light having respective wavelengths in the wavelength band (herein, from 8 um to 12 $\mu$m).

The internal transmittance of the base material 30 is a transmittance excluding a surface reflection loss on an incident side and an emitting side, which is well known in the art, and can be measured by using a method that is typically performed. The measurement is performed as follows, for example.

A pair of flat plate-shaped samples (a first sample and a second sample) are prepared, the samples that are constituted of base materials having the same composition and have different thicknesses. Both surfaces of the flat plate-shaped sample are planes that are parallel with each other and optically polished. Assuming that an external transmittance including a surface reflection loss of the first sample is T1, an external transmittance including a surface reflection loss of the second sample is T2, a thickness of the first sample is Td1 (mm), a thickness of the second sample is Td2 (mm), and Td1 < Td2 is satisfied, an internal transmittance $\tau$ with a thickness Tdx (mm) can be calculated by the following expression (1).

$$\tau = \exp\left[-Tdx \times (\ln T1 - \ln T2)/ \Delta Td\right] \qquad (1)$$

The external transmittance of infrared rays can be measured by a Fourier transform type infrared spectroscopic device (manufactured by Thermo Fisher Scientific Inc., trade name: Nicolet 1S10), for example.

A refractive index of the base material 30 with respect to light having a wavelength of 10 um is preferably equal to or larger than 1.5 and equal to or smaller than 4.0, more preferably equal to or larger than 2.0 and equal to or smaller than 4.0, and even more preferably equal to or larger than 2.2 and equal to or smaller than 3.5. An average refractive index of the base material 30 with respect to light having a wavelength from 8 um to 12 um is preferably equal to or larger than 1.5 and equal to or smaller than 4.0, more preferably equal to or larger than 2.0 and equal to or smaller than 4.0, and even more preferably equal to or larger than 2.2 and equal to or smaller than 3.5. When the refractive index and the average refractive index of the base material 30 fall within this numerical range, far-infrared rays can be appropriately transmitted, and the performance of the far-infrared camera CA1 can be sufficiently exhibited, for example. The average refractive index herein means an average value of refractive indexes with respect to pieces of light having respective wavelengths in the wavelength band (herein, from 8 um to 12 um). The refractive index can be determined by performing fitting of an optical model using polarization information obtained by an infrared spectroscopic ellipsometer (IR-VASE-UT manufactured by J.A. Woollam Japan.), for example, and a spectral transmission spectrum obtained by a Fourier transform type infrared spectroscopic device.

A thickness d0 of the base material 30 is preferably equal to or larger than 0.5 mm and equal to or smaller than 5 mm, more preferably equal to or larger than 1 mm and equal to or smaller than 4 mm, and even more preferably equal to or larger than 1.5 mm and equal to or smaller than 3 mm. When the thickness d0 falls within this range, far-infrared rays can be appropriately transmitted while securing strength. It can also be said that the thickness d0 is a length in the Z-direction from the surface 30a to the surface 30b of the base material 30.

A material of the base material 30 is not particularly limited, and examples thereof include Si, Ge, ZnS, chalcogenide glass, and the like. It can be said that the base material 30 preferably includes at least one material selected from the group consisting of Si, Ge, ZnS, and chalcogenide glass. By using such a material for the base material 30, far-infrared rays can be appropriately transmitted.

Preferred composition of the chalcogenide glass contains,

in atomic percentage,
Ge+Ga; 7% to 25%,
Sb; 0% to 35%,
Bi; 0% to 20%,
Zn; 0% to 20%,
Sn; 0% to 20%,
Si; 0% to 20%,
La; 0% to 20%,
S+Se+Te; 55% to 80%,
Ti; 0.005% to 0.3%,
Li+Na+K+Cs; 0% to 20%, and
F+Cl+Br+I; 0% to 20%. Additionally, this glass preferably has a glass transition point (Tg) of 140°C to 550°C.

As the material for the base material 30, Si, ZnS, and chalcogenide glass are more preferably used.

(Far-infrared ray transmission film)

The far-infrared ray transmission film 31 is a film that is formed on the base material 30 to suppress reflection of far-infrared rays.

As illustrated in FIG. 5, the far-infrared ray transmission film 31 according to the present embodiment includes a nickel oxide layer 32, a high refractive index layer 36, and a low refractive index layer 38. In the example of FIG. 5, the high refractive index layer 36 and the low refractive index layer 38 are alternately laminated between the base material 30 and the nickel oxide layer 32. That is, in the far-infrared ray transmission film 31, the nickel oxide layer 32 is formed on an outermost side (a side farthest from the base material 30). However, the nickel oxide layer 32 is not necessarily formed on the outermost side in the far-infrared ray transmission film 31. The high refractive index layer 36 or the low refractive index layer 38 may be formed on an outer side than the nickel oxide layer 32.

In the example of FIG. 5, the far-infrared ray transmission film 31 is laminated on the base material 30 in order of the high refractive index layer 36, the low refractive index layer 38, and the nickel oxide layer 32 toward a direction away from the base material 30. That is, in the example of FIG. 5, a surface 36b of the high refractive index layer 36 becomes a surface 31b on the base material 30 side of the far-infrared ray transmission film 31, and a surface 32a of the nickel oxide layer 32 becomes a surface 31a on the base material 30 side of the far-infrared ray transmission film 31. However, in the configuration including the nickel oxide layer 32, the high refractive index layer 36, and the low refractive index layer 38, a layer formed to be closest to the base material 30 side is not limited to the high refractive index layer 36 but may be the low refractive index layer 38, for example. For example, the low refractive index layer 38, the high refractive index layer 36, and the nickel oxide layer 32 may be laminated in this order in a direction away from the base material 30.

In the example of FIG. 5, the far-infrared ray transmission film 31 has a configuration in which the one high refractive index layer 36, the one low refractive index layer 38, and the one nickel oxide layer 32 are laminated, but the embodiment is not limited thereto. At least one of the high refractive index layer 36 and the low refractive index layers 38 may be laminated in layers. For example, in the far-infrared ray transmission member 20, the high refractive index layers 36 and the low refractive index layers 38 may be laminated on the base material 30 toward a direction away from the base material 30, and the nickel oxide layer 32 may be laminated on the outermost side (the side farthest from the base material 30). That is, the base material 30, the high refractive index layer 36, the low refractive index layer 38, the high refractive index layer 36, ... the low refractive index layer 38, and the nickel oxide layer 32 may be laminated in this order. Alternatively, in the far-infrared ray transmission member 20, the high refractive index layer 36 and the low refractive index layer 38 may be alternately laminated on the base material 30 toward a direction away from the base material 30, and the nickel oxide layer 32 may be laminated on the outermost side. That is, the base material 30, the low refractive index layer 38, the high refractive index layer 36, ... the low refractive index layer 38, and the nickel oxide layer 32 may be laminated in this order.

The far-infrared ray transmission film 31 may also have a layer configuration including the nickel oxide layer 32 and the high refractive index layer 36 but not including the low refractive index layer 38. In this case, the nickel oxide layer 32 functions as an intermediate refractive index layer (low refractive index layer) having a lower refractive index than that of the high refractive index layer 36. As the far-infrared ray transmission film 31, the one high refractive index layer 36 and the nickel oxide layer 32 may be laminated in this order, or the one nickel oxide layer 32 and the high refractive index layer 36 may be laminated in this order, on the base material 30 toward a direction away from the base material 30. Alternatively, as the far-infrared ray transmission film 31, at least one of the nickel oxide layer 32 and the high refractive index layer 36 may be laminated in layers. In this case, for example, as the far-infrared ray transmission film 31, the nickel oxide layer 32 and the high refractive index layer 36 may be alternately laminated, that is, the high refractive index layer 36, the nickel oxide layer 32, the high refractive index layer 36, ..., and the nickel oxide layer 32 may be laminated in this order, or the nickel oxide layer 32, the high refractive index layer 36, ... and the nickel oxide layer 32 may be laminated in this order, on the base material 30 toward a direction away from the base material 30.

Alternatively, the far-infrared ray transmission film 31 may have a layer configuration including the nickel oxide layer 32 and the low refractive index layer 38 but not including the high refractive index layer 36. In this case, the nickel oxide layer 32 functions as an intermediate refractive index layer (high refractive index layer) having a higher refractive index than that of the low refractive index layer 38. As the far-infrared ray transmission film 31, the one nickel oxide layer 32 and the one low refractive index layer 38 may be laminated in this order, or the one low refractive index layer 38 and the one nickel oxide layer 32 may be laminated in this order, on the base material 30 toward a direction away from the base material 30. Alternatively, as the far-infrared ray transmission film 31, at least one of the nickel oxide layer 32 and the low refractive index layer 38 may be laminated in layers. In this case, for example, as the far-infrared ray transmission film 31, the nickel oxide layer 32 and the low refractive index layer 38 may be alternately laminated, that is, the nickel oxide layer 32, the low refractive index layer 38, the nickel oxide layer 32, ..., and the low refractive index layer 38 may be laminated in this order, or the low refractive index layer 38, the nickel oxide layer 32, ... and the low refractive index layer 38 may be laminated in this order, on the base material 30 toward a direction away from the base material 30.

In a case in which a plurality of layers are laminated as described above, any of the three layers of the far-infrared ray transmission film 31 including the high refractive index layer 36, the low refractive index layer 38, and the nickel oxide layer 32 may be arranged on the base material 30 side. In a case in which the base material 30 is chalcogenide glass and/or ZnS, it is preferable that the layer arranged on the base material 30 side is the low refractive index layer 38 or the high refractive index layer 36 because reflection at an interface between the base material 30 and the far-infrared ray transmission film 31 can be reduced. On the other hand, in a case in which the base material 30 is Si and/or Ge, it is preferable that the layer arranged on the base material 30 side is the nickel oxide layer 32 or the low refractive index layer 38 because reflection at the interface between the base material and the far-infrared ray transmission film can be reduced. Irrespective of the material of the base material 30, it is preferable that the layer arranged on the base material 30 side is an Si layer because adhesion with respect to the base material is excellent. In this way, by laminating the nickel oxide layers 32, the high refractive index layers 36, and the low refractive index layers 38, a reflectance of light in a wider wavelength band can be suppressed.

It can be said that the far-infrared ray transmission film 31 does not necessarily include both of the high refractive index layer 36 and the low refractive index layer 38, and is characterized as including at least the one nickel oxide layer 32. That is, the far-infrared ray transmission film 31 may be a single layer film including the nickel oxide layer 32, or may be a multilayer film in which the nickel oxide layer 32 is laminated with at least one of the high refractive index layer 36 and the low refractive index layer 38. By causing the far-infrared ray transmission film 31 to be an antireflection film having a multilayer structure, a low reflectance can be easily achieved in a wider wavelength region using interferential action of light due to interface reflection light generated at each interface.

The far-infrared ray transmission film 31 formed on the vehicle interior side of the base material 30 and the far-infrared ray transmission film 31 formed on the vehicle exterior side may have different layer configurations.

(Nickel oxide layer)

The nickel oxide layer 32 is a layer containing nickel oxide ($NiO_x$) as a principal component, and can transmit far-infrared rays. It is known that the nickel oxide has a plurality of kinds of composition depending on a valence of nickel, and x can be an optional value from 0.5 to 2. The valence is not necessarily single, but two or more valences may be present. In the present embodiment, NiO is preferably used as $NiO_x$. The principal component herein may indicate that a content rate with respect to the entire nickel oxide layer 32 is equal to or higher than 50 mass%. An extinction coefficient of the nickel oxide layer 32 with respect to light having a wavelength of 10 um is preferably equal to or smaller than 0.05, more preferably equal to or smaller than 0.03, even more preferably equal to or smaller than 0.025, yet more preferably equal to or smaller than 0.02, and particularly preferably equal to or smaller than 0.01. An average extinction coefficient of the nickel oxide layer 32 with respect to light having a wavelength from 8 um to 12 um is preferably equal to or smaller than 0.05, more preferably equal to or smaller than 0.03, even more preferably equal to or smaller than 0.02, and particularly preferably equal to or smaller than 0.01. When the extinction coefficient and the average extinction coefficient fall within this range, far-infrared rays can be appropriately transmitted. The extinction coefficient with respect to light having a wavelength from 8 um to 12 um can be determined by performing fitting of an optical model using polarization information obtained by an infrared spectroscopic ellipsometer (IR-VASE-UT manufactured by J.A. Woollam Japan.), for example, and a spectral transmission spectrum obtained by a Fourier transform type infrared spectroscopic device (Nicolet 1S10 manufactured by Thermo Fisher Scientific Inc.).

A refractive index of the nickel oxide layer 32 with respect to light having a wavelength of 10 um (far-infrared rays) is preferably equal to or larger than 1.5 and equal to or smaller than 4.0, more preferably equal to or larger than 1.7 and equal to or smaller than 3.0, and even more preferably equal to or larger than 2.0 and equal to or smaller than 2.5. An average refractive index of the nickel oxide layer 32 with respect to light having a wavelength from 8 um to 12 um is preferably equal to or larger than 1.5 and equal to or smaller than 4.0, more preferably equal to or larger than 1.7 and equal to or smaller than 3.0, and even more preferably equal to or larger than 2.0 and equal to or smaller than 2.5. When the refractive index and the average refractive index of the nickel oxide layer 32 with respect to far-infrared rays fall within this numerical range, reflection of far-infrared rays can be suppressed, and far-infrared rays can be appropriately transmitted. The refractive index with respect to light having a wavelength from 8 um to 12 um can be determined by performing fitting of an optical model using polarization information obtained by an infrared spectroscopic ellipsometer, for example, and a spectral transmission spectrum obtained by a Fourier transform type infrared spectroscopic device.

An extinction coefficient of the nickel oxide layer 32 with respect to light having a wavelength of 550 nm is preferably equal to or larger than 0.04, more preferably equal to or larger than 0.05, even more preferably equal to or larger than 0.06, yet more preferably equal to or larger than 0.07, further more preferably equal to or larger than 0.08, and further more preferably equal to or larger than 0.10. An average extinction coefficient of the nickel oxide layer 32 with respect to light having a wavelength from 380 nm to 780 nm is preferably equal to or larger than 0.04, more preferably equal to or larger than 0.05, even more preferably equal to or larger than 0.06, yet more preferably equal to or larger than 0.07, further more preferably equal to or larger than 0.08, and further more preferably equal to or larger than 0.10. When the extinction coefficient and the average extinction coefficient fall within this range, reflectance dispersion of visible light can be appropriately suppressed, and external appearance securing designability can be obtained. The average extinction coefficient means an average value of extinction coefficients with respect to pieces of light having respective wavelengths in the wavelength band (herein, from 380 nm to 780 nm). The extinction coefficient with respect to light having a wavelength of 550 nm can be determined by performing fitting of an optical model using polarization information obtained by a spectroscopic ellipsometer, for example, and a spectral transmittance that is measured based on JIS R3106.

Regarding the nickel oxide layer 32, an element ratio between nickel and oxygen (O/Ni) is preferably equal to or larger than 1.0 and smaller than 1.3, more preferably equal to or larger than 1.0 and smaller than 1.25, and most preferably equal to or larger than 1.0 and smaller than 1.2. When O/Ni of the nickel oxide layer 32 falls within this numerical range, far-infrared rays can be appropriately transmitted. The element ratio (O/Ni) can be determined by Rutherford backscattering spectrometry or elastic recoil detection analysis, for example.

A film density of the nickel oxide layer 32 is preferably equal to or larger than 5.0 $g/cm^3$ and equal to or smaller than 6.0 $g/cm^3$, more preferably equal to or larger than 5.0 $g/cm^3$ and equal to or smaller than 5.8 g/cm3, and most preferably equal to or larger than 5.0 $g/cm^3$ and equal to or smaller than 5.4 $g/cm^3$. When the film density of the nickel oxide layer 32 falls within this numerical range, far-infrared rays can be appropriately transmitted. The film density can be determined by Rutherford backscattering spectrometry, for example.

Regarding the nickel oxide layer 32, an X-ray absorption edge energy value E(S) of a K-absorption edge of nickel is preferably equal to or smaller than 8347.1 eV, more preferably equal to or smaller than 8347.0 eV, and most preferably equal to or smaller than 8346.9 eV. When the X-ray absorption edge energy value E(S) of the K-absorption edge of nickel of the nickel oxide layer 32 falls within this numerical range, far-infrared rays can be appropriately transmitted.

The X-ray absorption edge energy value E(S) of the K-absorption edge of nickel of the nickel oxide layer 32 is obtained by performing X-ray Absorption Fine Structure (XAFS) measurement for the K-absorption edge of nickel on the nickel oxide layer 32 using the following procedure, for example, and evaluating an X-ray Absorption Near Edge Structure (XANES).

XAFS analysis is performed by an XAFS measurement beamline of a synchrotron radiation facility. Examples of the synchrotron radiation facility include Aichi Synchrotron Radiation Center, SPring-8, KEK Photon Factory, and SAGA Light Source. A spectroscope used for XAFS analysis is assumed to be Si(111). A fluorescent yield and an electron yield are detected at the same time. A measurement range is set to be a wide range so that lines of a pre-edge and a post-edge can be accurately drawn, specifically, measurement is performed in a wider range than 8100 to 8800 [eV]. In an edge region in which a spectrum changes abruptly, a measurement interval is set to be small so that a difference can be identified. Specifically, measurement is performed at intervals smaller than 0.18 [eV] at least in a range from 8320 to 8360 [eV].

After normalizing obtained data using analysis software Athena, a white line peak energy value is read, and this value is assumed to be Em(S) [eV]. For the purpose of calibrating a horizontal axis energy value, a transmission XAFS of an Ni foil is measured at the same measurement intervals and in the same measurement range as described above. After normalizing the obtained data using the analysis software Athena, an energy value with which an edge jump (a difference in absorbance before and after the absorption edge) becomes 0.5 is read, and this value is assumed to be Em(M) [eV]. By performing calculation based on the expression (2), the absorption edge energy value E(S) [eV] of the nickel oxide layer 32, that is, a peak top energy value of an XANES spectrum is obtained.

$$E(S) = Em(S) - Em(M) + 8337.9 \ldots \quad (2)$$

A thickness d1 of the nickel oxide layer 32 is preferably equal to or larger than 0.1 um and equal to or smaller than 2.0 um, more preferably equal to or larger than 0.2 um and equal to or smaller than 1.5 um, and even more preferably equal to or larger than 0.3 um and equal to or smaller than 1.4 um. When the thickness d1 falls within this range, reflection of far-infrared rays can be appropriately suppressed. It can also be said that the thickness d1 is a length in the Z-direction from the surface 32a of the nickel oxide layer 32 to a surface 32b on the opposite side.

The nickel oxide layer 32 may contain an accessory component, which is a component other than oxide (herein, nickel oxide) as the principal component. The accessory component is preferably oxide that transmits infrared rays, and examples thereof include $MgO$, $CuO_x$, $ZnO$, $ZrO_2$, $Bi_2O_3$, and $Y_2O_3$. A content rate of the accessory component is preferably equal to or lower than 50 mass%, more preferably equal to or lower than 30 mass%, and most preferably equal to or lower than 10 mass%. When the content rate of the accessory component falls within this range, water resistance and the like can be improved while appropriately transmitting far-infrared rays.

A surface arithmetic average roughness Ra of the nickel oxide layer 32 is preferably equal to or smaller than 4.0 nm, more preferably equal to or smaller than 3.0 nm, and most preferably equal to or smaller than 2.0 nm. When the surface roughness falls within this range, abrasion resistance and scratch resistance of the nickel oxide layer 32 can be improved. Ra can be determined by an atomic force microscope method, for example.

(High refractive index layer)

The high refractive index layer 36 is a film that is laminated with the nickel oxide layer 32 and the low refractive index layer 38 to suppress reflection of far-infrared rays. In the present embodiment, the high refractive index layer 36 is laminated to be closer to the base material 30 side than the nickel oxide layer 32, and disposed between the base material 30 and the low refractive index layer 38 in the example of FIG. 5. In a case in which the low refractive index layer 38 is not formed, the high refractive index layer 36 is disposed between the base material 30 and the nickel oxide layer 32.

The high refractive index layer 36 is a film having a high refractive index with respect to far-infrared rays. The refractive index with respect to light having a wavelength of 10 um is higher than that of the nickel oxide layer 32, preferably equal to or larger than 2.5 and equal to or smaller than 4.5, more preferably equal to or larger than 3.0 and equal to or smaller than 4.5, and even more preferably equal to or larger than 3.3 and equal to or smaller than 4.3. An average refractive index of the high refractive index layer 36 with respect to light having a wavelength from 8 um to 12 um is higher than that of the nickel oxide layer 32, preferably equal to or larger than 2.5 and equal to or smaller than 4.5, more preferably equal to or larger than 3.0 and equal to or smaller than 4.5, and even more preferably equal to or larger than 3.3 and equal to or smaller than 4.3. When the refractive index and the average refractive index of the high refractive index layer 36 fall within this numerical range, the high refractive index layer 36 can appropriately function as a high refractive index film, and can appropriately suppress reflection of far-infrared rays.

The high refractive index layer 36 can transmit far-infrared rays. An extinction coefficient of the high refractive index layer 36 with respect to light having a wavelength of 10 um is preferably equal to or smaller than 0.05, more preferably equal to or smaller than 0.02, and even more preferably equal to or smaller than 0.01. An average extinction coefficient of the high refractive index layer 36 with respect to light having a wavelength from 8 um to 12 um is preferably equal to or smaller than 0.05, more preferably equal to or smaller than 0.02, and even more preferably equal to or smaller than 0.01. When the extinction coefficient and the average extinction coefficient fall within this range, far-infrared rays can be appropriately transmitted.

A thickness d2 of the high refractive index layer 36 is preferably equal to or larger than 0.1 um and equal to or smaller than 2.0 um, more preferably equal to or larger than 0.2 um and equal to or smaller than 1.5 um, and even more preferably equal to or larger than 0.3 um and equal to or smaller than 1.2 um. When the thickness d2 falls within this range, reflection of far-infrared rays can be appropriately suppressed. It can also be said that the thickness d2 is a length in the Z-direction from a surface 36a of the high refractive index layer 36 to a surface 36b on the opposite side.

A material of the high refractive index layer 36 may be optional, but at least one material selected from the group consisting of Si and Ge may be contained as a principal component.

(Low refractive index layer)

The low refractive index layer 38 is a film that is laminated with the nickel oxide layer 32 and the high refractive index layer 36 to suppress reflection of far-infrared rays. In the present embodiment, the low refractive index layer 38 is laminated to be closer to the base material 30 side than the nickel oxide layer 32, and disposed between the high refractive index layer 36 and the nickel oxide layer 32 in the example of FIG. 5. In a case in which the high refractive index layer 36 is not formed, the low refractive index layer 38 is disposed between the base material 30 and the nickel oxide layer 32.

The low refractive index layer 38 is a film having a low refractive index with respect to far-infrared rays. The refractive index with respect to light having a wavelength of 10 um is lower than that of the nickel oxide layer 32, preferably equal to or larger than 0.8 and equal to or smaller than 2.0, more preferably equal to or larger than 1.0 and equal to or smaller than 1.7, and even more preferably equal to or larger than 1.0 and equal to or smaller than 1.5. An average refractive index of the low refractive index layer 38 with respect to light having a wavelength from 8 um to 12 um is lower than that of the nickel oxide layer 32, preferably equal to or larger than 0.8 and equal to or smaller than 2.0, more preferably equal to or larger than 1.0 and equal to or smaller than 1.7, and even more preferably equal to or larger than 1.0 and equal to or smaller than 1.5. When the refractive index and the average refractive index of the low refractive index layer 38 fall within this numerical range, the low refractive index layer 38 can appropriately function as a low refractive index film, and can appropriately suppress reflection of far-infrared rays.

The low refractive index layer 38 can transmit far-infrared rays. An extinction coefficient of the low refractive index layer 38 with respect to light having a wavelength of 10 um is preferably equal to or smaller than 0.05, more preferably equal to or smaller than 0.02, and even more preferably equal to or smaller than 0.01. An average extinction coefficient of the low refractive index layer 38 with respect to light having a wavelength from 8 um to 12 um is preferably equal to or smaller than 0.05, more preferably equal to or smaller than 0.02, and even more preferably equal to or smaller than 0.01. When the extinction coefficient and the average extinction coefficient fall within this range, far-infrared rays can be appropriately transmitted.

A thickness d3 of the low refractive index layer 38 is preferably equal to or larger than 0.1 um and equal to or smaller than 2.0 um, more preferably equal to or larger than 0.2 um and equal to or smaller than 1.7 um, and even more preferably equal to or larger than 0.3 um and equal to or smaller than 1.5 um. When the thickness d3 falls within this range, reflection of far-infrared rays can be appropriately suppressed. It can also be said that the thickness d3 is a length in the Z-direction from a surface 38a of the low refractive index layer 38 to a surface 38b on the opposite side.

The low refractive index layer 38 is preferably a film containing oxide as a principal component. More specifically, the low refractive index layer 38 preferably contains MgO as the oxide as a principal component. Regarding the low refractive index layer 38, a content rate of MgO with respect to the entire low refractive index layer 38 is preferably equal to or higher than 50 mass% and equal to or lower than 100 mass%, more preferably equal to or higher than 70 mass% and equal to or lower than 100 mass%, and even more preferably equal to or higher than 85 mass% and equal to or lower than 100 mass%. When the content rate of MgO falls within this range, the low refractive index layer 38 can appropriately transmit far-infrared rays, have a low refractive index with respect to far-infrared rays, and appropriately suppress reflection of far-infrared rays.

The low refractive index layer 38 may contain an accessory component, which is a component other than oxide (herein, MgO) as the principal component. The accessory component is preferably oxide that transmits infrared rays, and examples thereof include $CuO_x$, $ZnO$, $ZrO_2$, $Bi_2O_3$, and $Y_2O_3$.

(Adhesion layer)

An adhesion layer (not illustrated) may be formed between the far-infrared ray transmission film 31 and the base material 30. An adhesion film is a film that causes the base material 30 to adhere to the far-infrared ray transmission film 31, in other words, a film that improves bonding strength between the base material 30 and the far-infrared ray transmission film 31.

The adhesion layer is preferably capable of transmitting far-infrared rays. An extinction coefficient of the adhesion layer with respect to light having a wavelength of 10 um is preferably equal to or smaller than 0.10, more preferably equal to or smaller than 0.05, and even more preferably equal to or smaller than 0.04.

A refractive index of the adhesion layer with respect to light having a wavelength of 10 um is preferably equal to or larger than 1.4, more preferably equal to or larger than 1.4 and equal to or smaller than 3.6, and even more preferably equal to or larger than 1.6 and equal to or smaller than 2.2. When the refractive index of the adhesion layer falls within this numerical range, far-infrared rays can be appropriately transmitted. Additionally, single wavelength light (light from a laser light source emitting light having a wavelength from 0.8 um to 1.8 $\mu$m) can be appropriately transmitted. It can be said that the single wavelength light is light having a predetermined wavelength (single wavelength) in a wavelength range from 0.8 um to 1.8 um. Examples of the wavelength of the single wavelength light include 0.905 um (905 nm), 1.35 um (1350 nm), and 1.55 um (1550 nm).

The adhesion layer is preferably capable of transmitting single wavelength light. An extinction coefficient of the adhesion layer with respect to single wavelength light is preferably equal to or smaller than 0.10, more preferably equal to or smaller than 0.05, and even more preferably equal to or smaller than 0.04.

A refractive index of the adhesion layer with respect to single wavelength light is preferably equal to or larger than 1.4, more preferably equal to or larger than 1.4 and equal to or smaller than 3.6, and even more preferably equal to or larger than 2.0 and equal to or smaller than 2.4.

A thickness of the adhesion film is preferably equal to or larger than 0.05 um and equal to or smaller than 0.5 um, more preferably equal to or larger than 0.05 um and equal to or smaller than 0.3 um, and even more preferably equal to or larger than 0.05 um and equal to or smaller than 0.1 um. When the thickness of the adhesion film falls within this range, the base material 30 can be caused to appropriately adhere to the far-infrared ray transmission film 31 while appropriately suppressing reflection of single wavelength light and far-infrared rays. It can also be said that the thickness of the adhesion film is a length in the Z-direction from a surface on the Z-direction side of the adhesion film to a surface on the opposite side of the Z-direction. The thickness of the adhesion film is preferably smaller than the thickness of the far-infrared ray transmission film 31. When the thickness of the adhesion film is smaller than the thickness of the far-infrared ray transmission film 31, influence on optical performance can be reduced.

A material of the adhesion film is optional, but preferably contains at least one material selected from the group consisting of Si, Ge, MgO, $NiO_x$, $CuO_x$, ZnS, $Al_2O_3$, $ZrO_2$, $SiO_2$, $TiO_2$, ZnO, and $Bi_2O_3$, for example, and more preferably contains $ZrO_2$. By using such a material for the adhesion film, the base material 30 can be caused to appropriately adhere to the far-infrared ray transmission film 31.

(Characteristic of far-infrared ray transmission member)

As described above, in the far-infrared ray transmission member 20, the far-infrared ray transmission film 31 including at least one nickel oxide layer 32 is formed on the surface of the base material 30. When the far-infrared ray transmission film 31 including the nickel oxide layer 32 is formed on the surface of the base material 30, the far-infrared ray transmission member 20 can reduce reflectance of far-infrared rays, and enhance transmittance of far-infrared rays.

A transmittance of the far-infrared ray transmission member 20 with respect to light of 10 um is preferably equal to or larger than 50%, more preferably equal to or larger than 65%, and even more preferably equal to or larger than 70%. An average transmittance of the far-infrared ray transmission member 20 with respect to light having a wavelength from 8 um to 12 um is preferably equal to or larger than 50%, more preferably equal to or larger than 65%, and even more preferably equal to or larger than 70%. When the transmittance and the average transmittance fall within this range, a function as an infrared-ray transmission film can be appropriately exhibited. The average transmittance means an average value of transmittances with respect to pieces of light having respective wavelengths in the wavelength band (herein, from 8 um to 12 $\mu$m). The transmittance can be measured by a Fourier transform type infrared spectroscopic device (Nicolet 1S10 manufactured by Thermo Fisher Scientific Inc.), for example.

A reflectance of the far-infrared ray transmission member 20 with respect to light of 10 um is preferably equal to or smaller than 15%, more preferably equal to or smaller than 10%, and even more preferably equal to or smaller than 5%. An average reflectance of the far-infrared ray transmission member 20 with respect to light having a wavelength from 8 um to 12 um is preferably equal to or smaller than 15%, more preferably equal to or smaller than 10%, and even more preferably equal to or smaller than 5%. When the reflectance and the average reflectance fall within this range, a function as an infrared-ray transmission film can be appropriately exhibited. The average reflectance means an average value of reflectances with respect to pieces of light having respective wavelengths in the wavelength band (herein, from 8 um to 12 μm). The reflectance can be measured by a Fourier transform type infrared spectroscopic device (Nicolet 1S10 manufactured by Thermo Fisher Scientific Inc.), for example.

As illustrated in FIG. 3, a surface on the vehicle exterior side of the far-infrared ray transmission member 20 is preferably formed to be flush with (continuous to) a surface on the vehicle exterior side of the light blocking region A2. In other words, the surface 20A on the vehicle exterior side of the far-infrared ray transmission member 20 is attached to be continuous to the surface 12A of the glass base body 12. In this way, when the surface 20A of the far-infrared ray transmission member 20 is continuous to the surface 12A of the glass base body 12, a wiping effect of the wipers can be prevented from being deteriorated. Furthermore, it is possible to prevent the design of the vehicle V from being deteriorated due to a level difference, and prevent dust and the like from accumulating on the level difference. Additionally, the far-infrared ray transmission member 20 is preferably shaped in accordance with a curved surface shape of the glass 1 for vehicles to be applied. A method of shaping the far-infrared ray transmission member 20 is not particularly limited, but polishing or mold molding is selected in accordance with the curved surface shape or a film.

The shape of the far-infrared ray transmission member 20 is not particularly limited, but may be preferably a plate shape matching the shape of the opening 19. That is, in a case in which the opening 19 has a circular shape, for example, the far-infrared ray transmission member 20 may have a disc shape (cylinder shape). In view of design, a surface shape of the far-infrared ray transmission member 20 on the vehicle exterior side may be processed to match a curvature of an outer surface shape of the glass base body 12. Additionally, to achieve both of widening of a viewing angle of the far-infrared camera CA1 and improvement of mechanical characteristics, for example, the far-infrared ray transmission member 20 may be caused to have a lens shape. Such a configuration is preferable because far-infrared light can be efficiently collected even if the area of the far-infrared ray transmission member 20 is small. In this case, the number of far-infrared ray transmission members 20 having a lens shape is preferably 1 to 3, and typically preferably 2. Furthermore, it is particularly preferable that the far-infrared ray transmission member 20 having a lens shape is aligned and modularized in advance, and integrated with a housing for bonding the far-infrared camera CA1 to the glass 1 for vehicles, or a bracket.

The glass 1 for vehicles according to the present embodiment is preferably configured such that an area of the opening 19 on the surface on the vehicle interior side is smaller than an area of the opening 19 on the surface on the vehicle exterior side, and accordingly, an area on the surface on the vehicle interior side of the far-infrared ray transmission member 20 is preferably smaller than an area on the surface on the vehicle exterior side thereof. Such a configuration improves strength against impact from the vehicle exterior side. More specifically, in a case in which the glass 1 for vehicles according to the present embodiment is laminated glass including the glass base body 12 (vehicle exterior side) and the glass base body 14 (vehicle interior side), the opening 19 is formed by an opening 12a of the glass base body 12 and an opening 14a of the glass base body 14 overlapping each other. In this case, an area of the opening 12a of the glass base body 12 may be caused to be larger than an area of the opening 14a of the glass base body 14, and the far-infrared ray transmission member 20 matching the size of the opening 12a of the glass base body 12 may be arranged in the opening 12a of the glass base body 12.

As illustrated in FIG. 3, regarding the far-infrared ray transmission member 20, a length D1 of the longest straight line among straight lines each connecting optional two points in the surface on the vehicle exterior side is preferably equal to or smaller than 80 mm. The length D1 is more preferably equal to or smaller than 70 mm, and even more preferably equal to or smaller than 65 mm. The length D1 is also preferably equal to or larger than 60 mm. As illustrated in FIG. 3, regarding the opening 19 in the far-infrared ray transmission region B, a length D2 of the longest straight line among straight lines each connecting optional two points in the surface on the vehicle exterior side is preferably equal to or smaller than 80 mm. The length D2 is more preferably equal to or smaller than 70 mm, and even more preferably equal to or smaller than 65 mm. The length D2 is also preferably equal to or larger than 60 mm. It can also be said that the length D2 is the length of the longest straight line among straight lines each connecting optional two points on the outer circumference of the opening 19 on the surface on the vehicle exterior side (surface 12A) of the glass 1 for vehicles. By causing the length D1 of the far-infrared ray transmission member 20 and the length D2 of the opening 19 to fall within the range described above, the strength of the glass 1 for vehicles can be prevented from being lowered, and the perspective distortion amount in the periphery of the opening 19 can be suppressed. Each of the lengths D1 and D2 is a length corresponding to a diameter of the surface on the vehicle exterior side in a case in which the surface on the vehicle exterior side of the far-infrared ray transmission member 20 has a circular shape. Herein, each of the lengths D1 and D2 indicates a length in a state in which the glass 1 for vehicles is mounted on the vehicle V. For example, in a case of performing bending processing on the glass to have a shape to be mounted on the vehicle V, each of the lengths D1 and D2 is a length in a state after the bending processing is performed. The same applies to the description about dimensions or positions other than the lengths D1 and D2 unless otherwise noted.

(Manufacturing method for far-infrared ray transmission member)

Next, the following describes a manufacturing method for the far-infrared ray transmission member 20. In manufacturing the far-infrared ray transmission member 20, the base material 30 is prepared, a raw material target is arranged to be opposed to the base material 30, and the far-infrared ray transmission film 31 is formed by sputtering on the surface of the base material 30. Accordingly, the far-infrared ray transmission member 20 is manufactured. By forming the far-infrared ray transmission film 31 by sputtering, the uniform far-infrared ray transmission film 31 can be formed on the base material 30 having a larger area as compared with vapor deposition. Additionally, adhesion between the far-infrared ray transmission film 31 and the base material 30 can be improved.

In the present manufacturing method, the nickel oxide layer 32 of the far-infrared ray transmission film 31 is formed by sputtering using a mixed target of NiO and Ni. By using the mixed target as a raw material, the element ratio between nickel and oxygen (O/Ni) can be easily controlled, and the nickel oxide layer 32 having a high far-infrared ray transmittance can be formed.

A content rate of NiO in the mixed target is assumed to be equal to or higher than 30% and lower than 100% in mass ratio with respect to the entire mixed target. By causing the content rate of NiO in the mixed target to be equal to or higher than a lower limit value, a process window at the time of depositing NiO is widened, and the element ratio between nickel and oxygen (O/Ni) of the nickel oxide layer 32 can be easily controlled. On the other hand, by causing the content rate of NiO in the mixed target to be equal to or lower than an upper limit value, the target has electrical conductivity, and deposition can be performed by a DC pulse sputtering method, a Bi-polar pulse sputtering method, or an AC sputtering method (described later).

The content rate of NiO in the mixed target is preferably equal to or higher than 50% and equal to or lower than 95%, and most preferably equal to or higher than 70% and equal to or lower than 90% in mass ratio with respect to the entire mixed target.

Sputtering of the nickel oxide layer 32 is performed in a mixed atmosphere of Ar and oxygen. By performing sputtering in the mixed atmosphere of Ar and oxygen, it is possible to form the nickel oxide layer 32 having a high far-infrared ray transmittance in which the element ratio between nickel and oxygen is controlled.

At this point, a ratio of a volume flow rate (standard cc/min: SCCM, 1 atm (25°C)) of an oxygen gas in the mixed atmosphere is assumed to be equal to or higher than 1% and lower than 50%. By causing the volume flow rate ratio of the oxygen gas in the mixed atmosphere to be equal to or higher than 1% and lower than 50%, the element ratio between nickel and oxygen can be easily controlled, and the nickel oxide layer 32 having a high far-infrared ray transmittance can be formed. The volume flow rate ratio of the oxygen gas in the mixed atmosphere is more preferably equal to or higher than 1% and equal to or lower than 40%, and most preferably equal to or higher than 1% and equal to or lower than 30%.

Sputtering is preferably performed by a DC pulse sputtering method, a Bi-polar pulse sputtering method, or an AC sputtering method in view of uniformity of a film thickness, production stability, and oxidation degree controllability.

Alternatively, sputtering may be performed by a post-oxidation sputtering method in which deposition and oxidation are performed in separate rooms. In the post-oxidation sputtering method, the ratio of the volume flow rate of the oxygen gas in the mixed atmosphere in a deposition machine is assumed to be equal to or higher than 1% and lower than 50%. By causing the volume flow rate ratio of the oxygen gas in the mixed atmosphere in the deposition machine to be equal to or higher than 1% and lower than 50%, the element ratio between nickel and oxygen can be easily controlled, and the nickel oxide layer 32 having a high far-infrared ray transmittance can be formed. The volume flow rate ratio of the oxygen gas in the mixed atmosphere in the deposition machine is more preferably equal to or higher than 1% and equal to or lower than 40%, and most preferably equal to or higher than 1% and equal to or lower than 30%.

At the time of manufacturing the far-infrared ray transmission film 31, the base material 30 or the far-infrared ray transmission film 31 may be heated. A film stress of the far-infrared ray transmission film 31 is relieved by heating, and the adhesion between the base material 30 and the far-infrared ray transmission film 31 can be improved.

For example, after sputtering the far-infrared ray transmission film 31 on the surface of the base material 30, annealing processing may be performed on a surface of the far-infrared ray transmission film 31 on the opposite side of the base material 30 at a temperature equal to or higher than 100°C and lower than 300°C for a time equal to or longer than 0.5 hours and equal to or shorter than 2 hours. Due to this, the film stress of the far-infrared ray transmission film 31 is relieved, and the adhesion between the base material 30 and the far-infrared ray transmission film 31 can be improved without performing high-temperature annealing processing.

At the time of sputtering the far-infrared ray transmission film 31 on the base material 30, the base material 30 may be heated at a temperature equal to or higher than 100°C and lower than 300°C. Due to this, the film stress of the far-infrared ray transmission film 31 is relieved, and the adhesion between the base material 30 and the far-infrared ray transmission film 31 can be improved without performing high-temperature annealing processing.

(Other examples of present embodiment)

In the present embodiment, the far-infrared ray transmission member 20 has a configuration in which only the far-infrared ray transmission film 31 is formed on the base material 30, but the embodiment is not limited thereto. The following describes other examples of the far-infrared ray transmission member 20.

Fig. 6 is a schematic cross-sectional view of the far-infrared ray transmission film according to another example of the present embodiment. As illustrated in FIG. 6, in the far-infrared ray transmission member 20, a protective film 34 may be formed on the surface 31a of the far-infrared ray transmission film 31 on the opposite side of the base material 30. The protective film 34 is a film that is formed on an outer surface of the far-infrared ray transmission member 20, that is, a surface on the outermost side exposed to the outside, and protects the far-infrared ray transmission film 31 against damage caused by wiping or dust, corrosion caused by oil or a medical fluid, and the like. In the present embodiment, the protective film 34 is disposed on the far-infrared ray transmission film 31 on the vehicle exterior side, that is, the outer surface on the vehicle exterior side of the far-infrared ray transmission member 20, and is not disposed on the vehicle interior side. However, the protective film 34 may also be disposed on the far-infrared ray transmission film 31 on the vehicle interior side, that is, an outer surface on the vehicle interior side of the far-infrared ray transmission member 20. In the example of FIG. 6, for convenience of explanation, the far-infrared ray transmission film 31 is illustrated as a single layer. However, the far-infrared ray transmission film 31 is not limited to the single layer, and can have any layer configuration described above.

(Protective film)

The protective film 34 is preferably a harder film than the far-infrared ray transmission film 31. Specifically, a hardness $H_{IT}$ of the protective film 34 is preferably higher than that of the far-infrared ray transmission film 31. The hardness $H_{IT}$ is preferably higher than 9.0 GPa, more preferably higher than 10.0 GPa, and most preferably higher than 11 GPa. A value of $H_{IT}/E$, which is a ratio between $H_{IT}$ and a Young's modulus E, is preferably larger than that of the far-infrared ray transmission film 31, more preferably larger than 0.080, even more preferably larger than 0.090, and most preferably larger than 0.095. When values of $H_{IT}$ and $H_{IT}/E$ of the protective film 34 fall within this numerical range, the far-infrared ray transmission film 31 can be appropriately protected against damage caused by wiping or dust. The hardness $H_{IT}$ and the Young's modulus E are measured based on ISO14577.

A refractive index of the protective film 34 with respect to light having a wavelength of 550 nm (visible light) is preferably equal to or smaller than 2.5, more preferably equal to or larger than 1.5 and equal to or smaller than 2.5, and even more preferably equal to or larger than 1.7 and equal to or smaller than 2.4. An average refractive index of the protective film 34 with respect to light having a wavelength from 380 nm to 780 nm is preferably equal to or smaller than 2.5, more preferably equal to or larger than 1.5 and equal to or smaller than 2.5, and even more preferably equal to or larger than 1.7 and equal to or smaller than 2.4. When the refractive index and the average refractive index of the protective film 34 with respect to visible light fall within this numerical range, reflection of visible light can be suppressed by a combination of the protective film 34 and the nickel oxide layer 32, and the far-infrared ray transmission member 20 can be caused to be inconspicuous.

A refractive index of the protective film 34 with respect to light having a wavelength of 10 um (far-infrared rays) is preferably equal to or larger than 0.5 and equal to or smaller than 3.5, more preferably equal to or larger than 0.7 and equal to or smaller than 2.5, and even more preferably equal to or larger than 1.0 and equal to or smaller than 2.5. An average refractive index of the protective film 34 with respect to light having a wavelength from 8 um to 12 um is preferably equal to or larger than 0.5 and equal to or smaller than 3.5, more preferably equal to or larger than 0.7 and equal to or smaller than 2.5, and even more preferably equal to or larger than 1.0 and equal to or smaller than 2.5. When the refractive index and the average refractive index of the protective film 34 with respect to far-infrared rays fall within this numerical range, reflection of far-infrared rays can be suppressed, and far-infrared rays can be appropriately transmitted.

The protective film 34 can transmit far-infrared rays. An extinction coefficient of the protective film 34 with respect to light having a wavelength of 10 um is preferably equal to or smaller than 0.4, more preferably equal to or smaller than 0.2, and even more preferably equal to or smaller than 0.1. An average extinction coefficient of the protective film 34 with respect to light having a wavelength from 8 um to 12 um is preferably equal to or smaller than 0.4, more preferably equal to or smaller than 0.2, and even more preferably equal to or smaller than 0.1. When the extinction coefficient and the average extinction coefficient fall within this range, far-infrared rays can be appropriately transmitted.

A thickness d4 of the protective film 34 is preferably equal to or larger than 0.01 um and equal to or smaller than 1 $\mu$m, more preferably equal to or larger than 0.02 um and equal to or smaller than 0.5 um, and even more preferably equal to or larger than 0.05 um and equal to or smaller than 0.3 um. When the thickness d2 falls within this range, reflection of far-infrared rays and visible light can be appropriately suppressed. It can also be said that the thickness d2 is a length in the Z-direction from a surface 34a of the protective film 34 to a surface 34b on the opposite side.

A material of the protective film 34 is optional, but preferably contains at least one material selected from the

group consisting of $ZrO_2$, $Al_2O_3$, $TiO_2$, $Si_3N_4$, AlN, and diamond-like carbon, for example. By using such a material for the protective film 34, the far-infrared ray transmission film 31 can be appropriately protected.

The protective film 34 preferably has a water barrier property to protect the far-infrared ray transmission film 31 against water. That is, the protective film 34 preferably protects the far-infrared ray transmission film 31 against water to maintain external appearance of the far-infrared ray transmission film 31 in a visible light region. The water barrier property of the protective film 34 varies depending on a material, a crystal structure, and a film thickness. The protective film 34 preferably has an amorphous structure in view of the water barrier property.

The protective film 34 may be formed by sputtering similarly to the far-infrared ray transmission film 31, but the embodiment is not limited thereto. The protective film 34 may be formed by vapor deposition, for example.

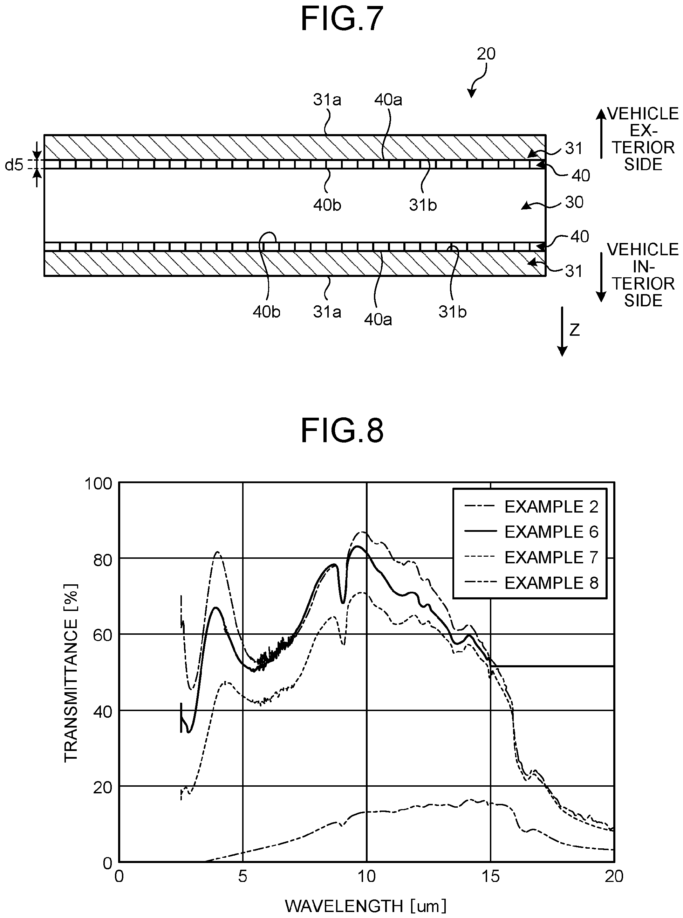

Fig. 7 is a schematic cross-sectional view of the far-infrared ray transmission film according to another example of the present embodiment. As illustrated in FIG. 7, in the far-infrared ray transmission member 20, an adhesion film 40 may be formed between the far-infrared ray transmission film 31 and the base material 30. Also in the example of FIG. 7, the protective film 34 as exemplified in FIG. 6 may be formed on the outer surface. Also in the example of FIG. 7, the far-infrared ray transmission film 31 is illustrated as a single layer. However, the far-infrared ray transmission film 31 is not limited to the single layer, but can have any layer configuration described above.

(Adhesion film)

The adhesion film 40 is a film that causes the base material 30 to adhere to the far-infrared ray transmission film 31, in other words, a film that improves bonding strength between the base material 30 and the far-infrared ray transmission film 31. The adhesion film 40 is disposed between the base material 30 and the far-infrared ray transmission film 31.

A refractive index of the adhesion film 40 with respect to light having a wavelength of 10 um (far-infrared rays) is preferably equal to or larger than 1.0 and equal to or smaller than 4.3, more preferably equal to or larger than 1.5 and equal to or smaller than 4.3, and even more preferably equal to or larger than 1.5 and equal to or smaller than 3.8. An average refractive index of the adhesion film 40 with respect to light having a wavelength from 8 um to 12 um is preferably equal to or larger than 1.0 and equal to or smaller than 4.3, more preferably equal to or larger than 1.5 and equal to or smaller than 4.3, and even more preferably equal to or larger than 1.5 and equal to or smaller than 3.8. When the refractive index and the average refractive index of the adhesion film 40 with respect to far-infrared rays fall within this numerical range, reflection of far-infrared rays can be suppressed, and far-infrared rays can be appropriately transmitted.

The adhesion film 40 can transmit far-infrared rays. An extinction coefficient of the adhesion film 40 with respect to light having a wavelength of 10 um is preferably equal to or smaller than 0.4, more preferably equal to or smaller than 0.2, and even more preferably equal to or smaller than 0.1. An average extinction coefficient of the adhesion film 40 with respect to light having a wavelength from 8 um to 12 um is preferably equal to or smaller than 0.4, more preferably equal to or smaller than 0.2, and even more preferably equal to or smaller than 0.1. When the extinction coefficient and the average extinction coefficient fall within this range, far-infrared rays can be appropriately transmitted.

A thickness d5 of the adhesion film 40 is preferably equal to or larger than 0.05 um and equal to or smaller than 0.5 um, more preferably equal to or larger than 0.05 um and equal to or smaller than 0.3 um, and even more preferably equal to or larger than 0.05 um and equal to or smaller than 0.1 um. When the thickness d5 falls within this range, reflection of far-infrared rays and visible light can be appropriately suppressed. It can also be said that the thickness d5 is a length in the Z-direction from a surface 40a of the adhesion film 40 to a surface 40b on the opposite side. The thickness d5 of the adhesion film 40 is preferably smaller than the thickness d1 of the nickel oxide layer 32, the thickness d2 of the high refractive index layer 36, and the thickness d3 of the low refractive index layer 38. When the thickness d5 of the adhesion film 40 is smaller than the thicknesses of these layers, influence on optical performance can be reduced.

A material of the adhesion film 40 is optional, but preferably contains at least one material selected from the group consisting of Si, Ge, MgO, $CuO_x$, ZnS, $Al_2O_3$, $ZrO_2$, $SiO_2$, $TiO_2$, ZnO, and $Bi_2O_3$, for example. By using such a material for the adhesion film 40, the base material 30 can be caused to appropriately adhere to the far-infrared ray transmission film 31.

The adhesion film 40 may be formed by sputtering similarly to the far-infrared ray transmission film 31, but the embodiment is not limited thereto. The adhesion film 40 may be formed by vapor deposition, for example.

(Effects)

As described above, in the manufacturing method for the far-infrared ray transmission member according to the present invention, the far-infrared ray transmission film including one or more nickel oxide layers is formed by sputtering using the mixed target of NiO and Ni on the base material that transmits far-infrared rays. At this point, the content rate of NiO in the mixed target is equal to or higher than 30 mass% and lower than 100 mass% with respect to the entire mixed target. Herein, the far-infrared ray transmission film is required to have a high far-infrared ray transmittance. There is a case in which a low-temperature process at a temperature lower than 300°C is required for expanding choices of the base material, suppressing peeling of a film caused by a thermal expansion difference, and reducing process cost. On the other hand, according to the manufacturing method for the far-infrared ray transmission film according to the present invention, the element ratio between nickel and oxygen of the nickel oxide layer can be appropriately controlled, a high-temperature process at a temperature equal to or higher than 300°C is not required, and the far-infrared ray transmission film having a high far-infrared ray transmittance can be formed.

The far-infrared ray transmission film 31 is formed by performing sputtering in the mixed atmosphere of an Ar gas and an oxygen gas under the condition that the volume flow rate ratio of oxygen in the mixed atmosphere is equal to or higher than 1% and lower than 50%. By forming the nickel oxide layer under the condition that the ratio of the volume flow rate of oxygen is lower than 50%, the element ratio between nickel and oxygen of the nickel oxide layer can be appropriately controlled, and the far-infrared ray transmission film having a high far-infrared ray transmittance can be formed without performing high-temperature annealing processing at a temperature equal to or higher than 300°C.

The far-infrared ray transmission film 31 is preferably formed while heating the base material 30 to a temperature equal to or higher than 100°C and lower than 300°C. By forming the nickel oxide layer 32 while heating the base material 30 to a temperature equal to or higher than 100°C and lower than 300°C, the film stress of the far-infrared ray transmission film 31 can be relieved, and the film can be prevented from peeling off.

The far-infrared ray transmission film 31 is preferably subjected to annealing processing at a temperature equal to or higher than 100°C and lower than 300°C. By performing annealing processing on the far-infrared ray transmission film 31 at a temperature equal to or higher than 100°C and lower than 300°C, the film stress of the far-infrared ray transmission film 31 can be relieved, coupling strength between the base material 30 and the far-infrared ray transmission film 31 can be enhanced, and the film can be prevented from peeling off.

At this point, the annealing processing is preferably performed for a time equal to or longer than 0.5 h and equal to or shorter than 2 h in view of relieving the film stress of the far-infrared ray transmission film 31, enhancing coupling strength between the base material 30 and the far-infrared ray transmission film 31, and easily suppressing peeling of the film.

The base material 30 preferably contains at least one material selected from the group consisting of Si, Ge, ZnS, and chalcogenide glass. By using such a material for the base material 30, far-infrared rays can be appropriately transmitted.

The far-infrared ray transmission member 20 is preferably mounted on a vehicle. The far-infrared ray transmission member 20 can appropriately transmit far-infrared rays, so that the far-infrared ray transmission member 20 can be appropriately mounted on the vehicle.

The far-infrared ray transmission member 20 may be arranged on a window member of the vehicle. The far-infrared ray transmission member 20 can appropriately transmit far-infrared rays, so that the far-infrared ray transmission member 20 can be appropriately mounted on the vehicle.

The far-infrared ray transmission member 20 may be arranged on an exterior member for a pillar of the vehicle. The far-infrared ray transmission member 20 can appropriately transmit far-infrared rays, so that the far-infrared ray transmission member 20 can be appropriately mounted on the vehicle.

The far-infrared ray transmission member 20 may be arranged in the light blocking region A2 of an exterior member for the vehicle. The far-infrared ray transmission member 20 can appropriately transmit far-infrared rays, so that the far-infrared ray transmission member 20 can be appropriately mounted on the vehicle.

(Examples)

The following specifically describes the present invention with examples, but the present invention is not limited thereto. Table 1 indicates the examples. In Table 1, as a film configuration of the far-infrared ray transmission film, only one surface of the substrate is indicated. However, the same far-infrared ray transmission film is formed on an opposite surface of the substrate.

[Table 1]

Table 1

| | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Configuration of far-infrared ray transmission member | | | NiO 1200nm | NiO 1200nm | NiO 1200nm | NiO 1200nm | NiO 1200nm | NiO 1200nm | NiO 1200nm | NiO 1200nm | NiO 1200nm |
| | | Si substrate | Si substrate | Si substrate | Si substrate | Si substrate | Si substrate | Si substrate | Si substrate | Si substrate | Si substrate |
| Nickel Oxide layer deposition condition | Target material | - | NiO+Ni | NiO+Ni | NiO+Ni | Ni | NiO+Ni | NiO+Ni | NiO+Ni | Ni | Ni |
| | NiO volume ratio in target | - | 70% | 70% | 70% | 0% | 70% | 70% | 70% | 0% | 0% |
| | Volume flow rate ratio of oxygen gas at time of deposition | - | 20% | 20% | 20% | 27% | 33% | 50% | 100% | - | - |
| | Heating condition | - | None | 150°C, 1h anneal | 250°C, substrate heating deposition | None | None | None | None | None | 600°C, 1h anneal |
| Evaluation of far-infrared ray transmission member | FIR transmittance | 50.3 | 79.8 | 81.2 | 81.4 | 73.1 | 76.2 | 65.1 | 11.8 | 73.6 | 81.2 |
| | Transmission property | × | ◎ | ◎ | ◎ | × | ○ | × | × | × | ◎ |
| | Boiling test | ○ | × | ○ | ○ | × | × | × | × | - | - |

EP 4 343 392 A1

(Example 1)

In the example 1, the base material itself was the far-infrared ray transmission member, and the far-infrared ray transmission film was not formed. In the example 1, Si (100 orientation, CZ grade, P-type, manufactured by MATSUZAKI SEISAKUSHO CO., LTD.) both surfaces of which are subjected to mirror polishing was used as the base material. The thickness of the base material was set to be 0.525 mm ± 0.025 mm.

(Example 2)

In the example 2, nickel oxide layers were respectively formed on both surfaces of the base material by magnetron sputtering to be far-infrared ray transmission films. In the example 2, the same Si as that in the example 1 was used as the base material, the thickness of the base material was the same as that in the example 1, and the thickness of the nickel oxide layer was set to be 1.2 um. Thicknesses of the base material and the nickel oxide layer were evaluated by a stylus type profiling system (Dektak XT-S, manufactured by Bruker Corporation).

As a deposition raw material, a mixed target of NiO and Ni (manufactured by Kojundo Chemical Laboratory Co., Ltd.) was used. A mass ratio of NiO in the mixed target was 70%, and a mass ratio of Ni was 30%. The mixed target described above and the base material were arranged to be opposed to each other in a deposition device. At this point, a distance between the target and the substrate was set to be 150 mm. Next, the entire device was evacuated to vacuum. At the time when a pressure inside the device reached $5 \times 10^{-4}$Pa, 150 SCCM (standard cc/min, 1 atm (25°C)) of mixed atmosphere of an Ar gas and an oxygen gas in total was caused to flow. The volume flow rate ratio of the oxygen gas in the mixed atmosphere was assumed to be 20%, and an evacuation speed was adjusted so that the pressure inside the device becomes 0.3 Pa. Thereafter, 3000 W of DC pulse current (20 kHz) was applied to a target surface, the nickel oxide layer was formed on the surface of the base material while rotating the base material in front of the target, and the far-infrared ray transmission member was made.

(Example 3)

The far-infrared ray transmission member was made by using the same method as that in the example 2 except that the surface of the obtained nickel oxide layer was subjected to annealing processing for 1 hour at 150°C in air atmosphere.

(Example 4)

The far-infrared ray transmission member was made by using the same method as that in the example 2 except that the nickel oxide layer was formed while heating the Si substrate at 250°C.

(Example 5)

By using a deposition device different from that in the example 2, the same base material as that in the example 2 and a pure nickel target (manufactured by Kojundo Chemical Laboratory Co., Ltd.) were arranged to be opposed to each other. At this point, a distance between the target and the substrate was set to be 90 mm. After evacuating the entire device to vacuum similarly to the example 2, 15 SCCM of the mixed atmosphere of the Ar gas and the oxygen gas in total was caused to flow therein. At this point, the volume flow rate ratio of the oxygen gas in the mixed atmosphere was assumed to be 27%, and the evacuation speed was adjusted so that the pressure inside the device becomes 0.3 Pa. Thereafter, 400 W of DC pulse current (20 kHz) was applied to a target surface, the nickel oxide layer was formed on the surface of the base material while rotating the base material in front of the target, and the far-infrared ray transmission member was made.

(Example 6)

The far-infrared ray transmission member was made by using the same method as that in the example 2 except that the volume flow rate ratio of the oxygen gas in the mixed atmosphere was set to be 33%.

(Example 7)

The far-infrared ray transmission member was made by using the same method as that in the example 2 except that the volume flow rate ratio of the oxygen gas in the mixed atmosphere was set to be 50%.

(Example 8)

The far-infrared ray transmission member was made by using the same method as that in the example 2 except that the volume flow rate ratio of the oxygen gas in the mixed atmosphere was set to be 100%.

(Example 9)

The data of Table 3 in Non Patent Literature 2 was applied to make the far-infrared ray transmission member. Nickel oxide layers are respectively formed, by using an RF magnetron sputtering method, on both surfaces of the base material made of Si (100 orientation, P-type) both surfaces of which are subjected to mirror polishing, and the far-infrared ray transmission member was obtained. The thickness of the base material was set to be 0.525 mm, and the thickness of the nickel oxide layer was set to be 1.2 um.

As the deposition raw material, the same pure Ni target as that in the example 5 was used. The entire deposition device was evacuated to vacuum, and when the pressure in the device reached $3 \times 10^{-6}$ Torr, the mixed atmosphere of the Ar gas and the oxygen gas was caused to flow. At this point, the evacuation speed was adjusted so that the pressure in the device becomes 3.5 mTorr. Thereafter, an RF current was applied to the target surface, and the nickel oxide layer was formed on the surface of the base material to make the far-infrared ray transmission member.

(Example 10)

The far-infrared ray transmission member was made by using the same method as that in the example 10 except that the data of Non Patent Literature 2 was applied, and the surface of the obtained nickel oxide layer was subjected to annealing processing for 1 hour at 600°C in the air atmosphere.

(Evaluation of far-infrared ray transmission performance)

Evaluation of far-infrared ray transmission performance was performed for samples in the example 1 to the example 8. The far-infrared ray transmission performance was evaluated based on an average transmittance of the samples. Herein, the average transmittance is an average value of the transmittances with respect to pieces of light having respective wavelengths from 8 um to 12 um. In the example 1 to the example 8, the transmittances with respect to pieces of light having respective wavelengths from 8 um to 12 um were measured by using a Fourier transform type infrared spectroscopic device (manufactured by Thermo Fisher Scientific Inc., trade name: Nicolet 1S10), and an arithmetic average transmittance was calculated from the measured transmittances. A measurement range was assumed to be 400 cm$^{-1}$ to 4000 cm$^{-1}$, and a measurement interval was assumed to be 2 cm$^{-1}$. In evaluation of the far-infrared ray transmission performance, the average transmittance equal to or higher than 78% was represented by a double circle, the average transmittance equal to or higher than 75% and lower than 78% was represented by a circle, the average transmittance lower than 75% was represented by a cross, and the circle and the double circle were accepted.

Next, for samples in the example 9 and the example 10, description of Table 3 in Non Patent Literature 2 was applied to evaluate the far-infrared ray transmission performance. The far-infrared ray transmission performance was evaluated based on the average transmittance measured by using a Fourier transform type infrared spectroscopic device (FT-IR). In evaluation of the far-infrared ray transmission performance, the average transmittance equal to or higher than 78% was represented by a double circle, the average transmittance equal to or higher than 75% and lower than 78% was represented by a circle, the average transmittance lower than 75% was represented by a cross, and the circle and the double circle were accepted.

Table 1 indicates the far-infrared ray transmission performance of the samples in the example 1 to the example 10. FIG. 8 illustrates infrared ray transmission performance of the samples in the example 2, the example 6, the example 7, and the example 8. With reference to Table 1, favorable transmission performance was confirmed in the example 2, the example 3, the example 4, the example 6, and the example 10, but the transmission performance was insufficient in the example 1, the example 5, the example 7, the example 8, and the example 9. With reference to FIG. 8, favorable transmission performance was confirmed in the example 2 and the example 6, but the transmission performance was insufficient in the example 7 and the example 8.

The samples in the example 2, the example 3, the example 4, and the example 6 are made by using the mixed target of NiO and Ni under the condition that the volume flow rate ratio of the oxygen gas at the time of deposition is lower than 50%, and it can be found that the element ratio between nickel and oxygen (O/Ni) in the nickel oxide layer is appropriately controlled under the condition, a high-temperature process at a temperature equal to or higher than 300 °C is not required, and an oxide film having a high far-infrared ray transmittance can be obtained. The samples in the example 7 and the example 8 are made by using the mixed target of nickel oxide and nickel under the condition that the volume flow rate ratio of the oxygen gas at the time of deposition is equal to or higher than 50%, and it can be considered that the element ratio between nickel and oxygen (O/Ni) in the nickel oxide layer is inappropriate under the condition, and the far-infrared ray transmittance is attenuated.

In the example 10, it is estimated that a pure Ni target not containing NiO is used and annealing processing is performed for 1 hour at a high temperature of 600°C, so that density of defects is reduced and the nickel oxide layer having a high far-infrared ray transmittance is obtained. The samples in the example 5 and the example 9 are made by using a pure Ni target not including a mass ratio of NiO, and it can be considered that an oxygen element ratio in the nickel oxide layer is inappropriate under the condition, and the far-infrared ray transmittance is attenuated.

(Evaluation of water resistance)

Furthermore, evaluation of water resistance was performed for the samples in the example 1 to the example 10. In evaluation of water resistance performance, a boiling test was performed. A sample passed the boiling test was represented by a circle, and a sample failed in the boiling test was represented by a cross. The boiling test was performed by holding a film deposition substrate for 10 minutes in pure water of 100°C $\pm$ 3°C. After the boiling test, a sample from which a film was peeled off, or a sample in which the average transmittance with respect to 8 um to 12 um varied by 50 or more was rejected. As indicated by the example 3 and the example 4, it is more preferable to heat the nickel oxide layer to 100°C or more because durability of the boiling test can be improved.

(Evaluation of nickel oxide layer)

Furthermore, for the samples in the example 2 and the example 9, the film density and the element ratio (O/Ni) of the nickel oxide layer was evaluated by Rutherford backscattering spectrometry using a pelletron tandem accelerator system 3SDH (manufactured by National Electrostatics Corporation).

Additionally, for the samples in the example 2, the example 6, the example 7, and the example 8, optical fitting was performed based on polarization information obtained by an infrared spectroscopic ellipsometer (manufactured by J.A. Woollam Japan., IR-VASE-UT), and the extinction coefficient with respect to light having a wavelength of 10 um was evaluated. Results are indicated by Table 2. As indicated by Table 2, in the example 2, obtained was the nickel oxide layer the element ratio (O/Ni) of which was equal to or smaller than 1.3, and the film density of which was equal to or smaller than 6.0 g/cm$^3$.

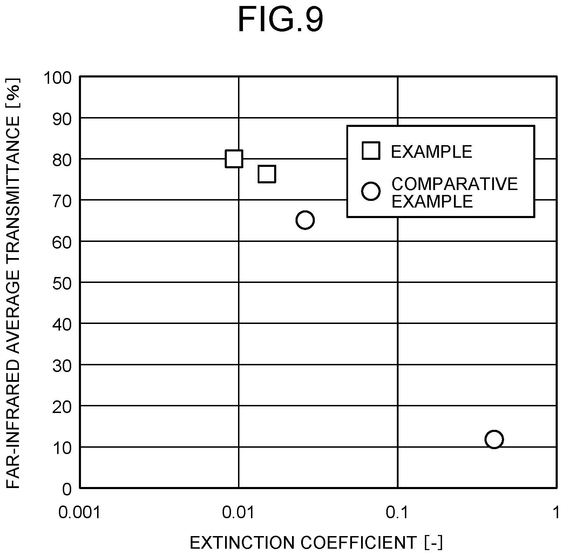

FIG. 9 illustrates a relation between the average transmittance of the samples in the example 2, the example 6, the example 7, and the example 8 with respect to light having a wavelength from 8 um to 12 um and the extinction coefficient of the nickel oxide layer with respect to light having a wavelength of 10 um. With reference to FIG. 9, it was confirmed that the nickel oxide layer having more excellent far-infrared ray performance could be obtained as the extinction coefficient with respect to light having a wavelength of 10 um was smaller. In the example 2 and the example 6, the nickel oxide layer having excellent far-infrared ray transmission performance was obtained such that the extinction coefficient with respect to light having a wavelength of 10 um was equal to or smaller than 0.025.

(XANES evaluation of nickel oxide layer)

Furthermore, for the samples in the example 2, the example 6, the example 7, and the example 8, XAFS measurement for the K-absorption edge of nickel was performed, and XANES was evaluated.

In the measurement, XAFS analysis was performed with hard X-rays using a beamline BL5S1 of Aichi Synchrotron Radiation Center. A spectroscope was assumed to be Si(111). Detection was performed for fluorescent yield and an electron yield at the same time. A measurement range was set to be a wide range so that lines of a pre-edge and a post-edge could be accurately drawn, specifically, measurement was performed in a wider range than 8100 to 8800 [eV]. In an edge region in which a spectrum changed abruptly, a measurement interval was set to be small so that a difference could be identified. Specifically, measurement was performed at intervals smaller than 0.18 [eV] at least for a range from 8320 to 8360 [eV].

After normalizing obtained data using analysis software Athena, a white line peak energy value was read, and this value was assumed to be Em(S) [eV]. For the purpose of calibrating a horizontal axis energy value, a transmission XAFS of an Ni foil was measured at the same measurement intervals and in the same measurement range as described above. After normalizing the obtained data using the analysis software Athena, an energy value with which an edge jump became 0.5 was read, and this value was assumed to be Em(M) [eV]. Calculation was performed based on the expression (2), and the absorption edge energy value E(S) [eV] of each sample, that is, a peak top energy value of an XANES spectrum was obtained.

$$E(S) = Em(S) - Em(M) + 8337.9 \tag{2}$$

As indicated by Table 2, in the example 2 and the example 6, the nickel oxide layer having excellent far-infrared ray transmission performance was obtained such that E(S) was equal to or smaller than 8347.1 eV.

Table 2

|  | Example 2 | Example 6 | Example 7 | Example 8 |
|---|---|---|---|---|
| Oxygen gas flow rate ratio at time of deposition[%] | 20 | 33 | 50 | 100 |
| FIR transmittance[%] | 79.8 | 76.2 | 65.1 | 11.8 |
| O/Ni | 1.17 | - | - | 1.3 |
| Film density[g/cm$^3$] | 5.3 | - | - | 6.1 |
| Em(S)[eV] | 8346.82 | 8346.96 | 8347.11 | 8347.41 |
| Em(M)[eV] | 8337.9 | 8337.9 | 8337.9 | 8337.9 |
| E(S)[eV] | 8346.82 | 8346.96 | 8347.11 | 8347.41 |
| Extinction coefficient | 0.0094 | 0.015 | 0.026 | 0.40 |

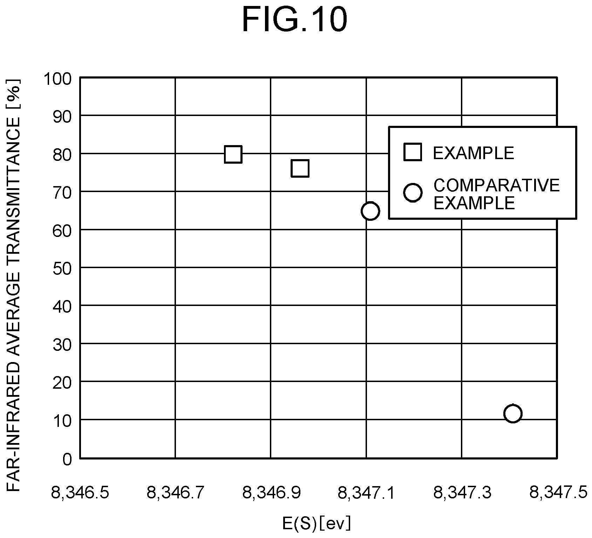

FIG. 10 illustrates a relation between E(S) and the average transmittance of the samples in the example 2, the example 6, the example 7, and the example 8 with respect to light having a wavelength from 8 um to 12 um. With reference to FIG. 10, it was confirmed that the nickel oxide layer having more excellent far-infrared ray transmission performance could be obtained as E(S) was smaller. In the example 2 and the example 6, the nickel oxide layer having excellent far-infrared ray performance was obtained such that E(S) was equal to or smaller than 8347.1 eV.

The embodiment of the present invention has been described above, but the embodiment is not limited thereto. The constituent elements described above include a constituent element that is easily conceivable by those skilled in the art, substantially the same constituent element, and what is called an equivalent. Furthermore, the constituent elements described above can be appropriately combined. In addition, the constituent elements can be variously omitted, replaced, or modified without departing from the gist of the embodiments described above.

Reference Signs List

1          GLASS FOR VEHICLES

10, 12, 14     GLASS BASE BODY

16         INTERMEDIATE LAYER

18         LIGHT BLOCKING LAYER

20         FAR-INFRARED RAY TRANSMISSION MEMBER

30         BASE MATERIAL

31         FAR-INFRARED RAY TRANSMISSION FILM

32         NICKEL OXIDE LAYER

34         PROTECTIVE FILM

36         HIGH REFRACTIVE INDEX LAYER

38         LOW REFRACTIVE INDEX LAYER

40         ADHESION FILM

**Claims**

1. A manufacturing method for a far-infrared ray transmission member includes,

    forming a far-infrared ray transmission film including one or more nickel oxide layers on a base material that transmits far-infrared rays by performing sputtering in a mixed atmosphere of an Ar gas and an oxygen gas using a mixed target of NiO and Ni, wherein
    a content rate of NiO in the mixed target is equal to or higher than 30 mass% and lower than 100 mass% with respect to the entire mixed target, and a volume flow rate ratio of the oxygen gas in the mixed atmosphere is equal to or higher than 1% and lower than 50% with respect to a total volume flow rate of the Ar gas and the oxygen gas.

2. The manufacturing method for the far-infrared ray transmission member according to claim 1, wherein the content rate of NiO in the mixed target is equal to or higher than 50 mass% and equal to or lower than 95% mass% with respect to the entire mixed target.

3. The manufacturing method for the far-infrared ray transmission member according to claim 1 or 2, wherein the content rate of NiO in the mixed target is equal to or higher than 70 mass% and equal to or lower than 90 mass% with respect to the entire mixed target.

4. The manufacturing method for the far-infrared ray transmission member according to any one of claims 1 to 3, wherein the sputtering is performed by a DC pulse sputtering method, an AC sputtering method, or a Bi-polar pulse sputtering method.

5. The manufacturing method for the far-infrared ray transmission member according to any one of claims 1 to 4, wherein the base material is heated to a temperature equal to or higher than 100°C and lower than 300°C.

6. The manufacturing method for the far-infrared ray transmission member according to any one of claims 1 to 5, wherein a surface on the opposite side of the base material of the far-infrared ray transmission film is subjected to annealing processing at a temperature equal to or higher than 100°C and lower than 300°C.

7. The manufacturing method for the far-infrared ray transmission member according to any one of claims 1 to 6, wherein the base material contains at least one material selected from the group consisting of Si, Ge, ZnS, and chalcogenide glass.

8. The manufacturing method for the far-infrared ray transmission member according to any one of claims 1 to 7, wherein the far-infrared ray transmission member is mounted on a vehicle.

9. The manufacturing method for the far-infrared ray transmission member according to claim 8, wherein the far-infrared ray transmission member is arranged on a window member of the vehicle.

10. The manufacturing method for the far-infrared ray transmission member according to claim 8 or 9, wherein the far-infrared ray transmission member is arranged on an exterior member for a pillar of the vehicle.

11. The manufacturing method for the far-infrared ray transmission member according to any one of claims 8 to 10, wherein the far-infrared ray transmission member is arranged in a light blocking region of an exterior member for a vehicle.

12. A far-infrared ray transmission member comprising a base material that transmits far-infrared rays and a functional film formed on the base material, wherein
    the functional film includes one or more nickel oxide layers in which peak top energy of an X-ray Absorption Fine Structure (XANES) spectrum of a K-absorption edge of nickel is equal to or smaller than 8347.1 eV.

13. A far-infrared ray transmission member comprising a base material that transmits far-infrared rays and a functional film formed on the base material, wherein
    the functional film includes one or more nickel oxide layers having an extinction coefficient with respect to light having a wavelength of 10 um equal to or smaller than 0.025.

14. The far-infrared ray transmission member according to claim 12 or 13, wherein an element ratio between nickel and oxygen (O/Ni) of the nickel oxide layer is equal to or larger than 1.0 and smaller than 1.3.

15. The far-infrared ray transmission member according to any one of claims 12 to 14, wherein film density of the nickel oxide layer is equal to or larger than 5.0 $g/cm^3$ and equal to or smaller than 6.0 $g/cm^3$.

# FIG.1

# FIG.2

# FIG.3

VEHICLE
EXTERIOR SIDE

VEHICLE
INTERIOR SIDE

# FIG.4

# FIG.5

# FIG.6

# FIG.7

# FIG.8

# FIG.9

# FIG.10

## INTERNATIONAL SEARCH REPORT

| International application No. |
|---|
| **PCT/JP2022/020170** |

### A. CLASSIFICATION OF SUBJECT MATTER

*G02B 5/22*(2006.01)i; *B60J 1/00*(2006.01)i; *C01G 53/04*(2006.01)i; *C03C 17/245*(2006.01)i; *C23C 14/08*(2006.01)i; *C23C 14/34*(2006.01)i
FI: G02B5/22; C03C17/245 A; C01G53/04; C23C14/08 J; C23C14/34 A; C23C14/34 M; B60J1/00 H

According to International Patent Classification (IPC) or to both national classification and IPC

### B. FIELDS SEARCHED

Minimum documentation searched (classification system followed by classification symbols)

G02B5/22; B60J1/00; C01G53/04; C03C17/245; C23C14/08; C23C14/34

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | SHIM, Hyunbin et al. Nickel-oxide film as an AR coating of Si window for IR sensor packaging. Proceedings of SPIE vol.8704, Infrared Technology and Applications XXXIX. 18 June 2013, 870420, pp. 1-6, doi:10.1117/12.2013929 abstract, page 2, lines 1-9, page 5, lines 1-10, fig. 5, table 3 | 12-15 |
| A | | 1-11 |
| A | JP 2018-36325 A (TOKAI KOGAKU KK) 08 March 2018 (2018-03-08) claims, examples 1-10 | 1-15 |
| A | JP 2016-504484 A (HERAEUS DEUTSCHLAND GMBH & CO. KG) 12 February 2016 (2016-02-12) entire text, all drawings | 1-11 |
| P, X | WO 2022/065000 A1 (AGC INC.) 31 March 2022 (2022-03-31) claims, particularly, claim 4, paragraphs [0029], [0050], [0052], examples 3, 6-11, 15, 16, particularly, example 15 | 12-15 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **08 July 2022** | **26 July 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

32

**INTERNATIONAL SEARCH REPORT**
Information on patent family members

International application No.

**PCT/JP2022/020170**

| Patent document cited in search report | | | Publication date (day/month/year) | Patent family member(s) | | | Publication date (day/month/year) |
|---|---|---|---|---|---|---|---|
| JP | 2018-36325 | A | 08 March 2018 | (Family: none) | | | |
| JP | 2016-504484 | A | 12 February 2016 | WO | 2014/063953 | A2 | |
| | | | | entire text, all drawings | | | |
| | | | | WO | 2014/063954 | A1 | |
| | | | | DE | 102012112739 | A1 | |
| | | | | DE | 102012112742 | A1 | |
| | | | | TW | 201430158 | A | |
| | | | | TW | 201434659 | A | |
| | | | | KR | 10-2015-0079810 | A | |
| | | | | KR | 10-2015-0079811 | A | |
| | | | | CN | 104919340 | A | |
| | | | | CN | 104937443 | A | |
| | | | | JP | 2016-502592 | A | |
| WO | 2022/065000 | A1 | 31 March 2022 | (Family: none) | | | |

Form PCT/ISA/210 (patent family annex) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HYUN BIN SHIM et al.** Controlling the infrared optical properties of rf-sputtered NiO films for application of infrared window. *Infrared Physics and Technology,* 2015, vol. 72, 135-139

- **HYUN BIN SHIM et al.** Nickel oxide film as an AR coating of Si window for IRsensor packaging. *Infrared Technology and Applications XXXIX, Proc. of SPIE,* vol. 8704, 870420-1